# EUROPEAN PATENT APPLICATION

(11) **EP 1 816 152 A1**
(43) Date of publication of application: **08.08.2007**
(21) Application number: 05809475.6
(22) Date of filing: 24.11.2005
(51) Int. Cl.: C08G 59/72, H01L 23/29, H01L 23/31, C08G 65/18

(54) **POLYMERIZABLE COMPOSITION**

(30) Priority: 26.11.2004 JP 2004341597; 10.12.2004 JP 2004357990; 17.06.2005 JP 2005177454
(71) Applicant: TOYO INK MFG. CO., LTD., Tokyo 104-0031 (JP)
(72) Inventor: KANNO, Masaki c/o Toyo Ink Mfg. Co., Ltd., Tokyo 104-0031 (JP); TSUSHIMA, Nozomi c/o Toyo Ink Mfg. Co., Ltd., Tokyo 104-0031 (JP); UESUGI, Takahiko c/o Toyo Ink Mfg. Co., Ltd., Tokyo 104-0031 (JP); MATSUMOTO, Seiya c/o Toyo Ink Mfg. Co., Ltd., Tokyo 104-0031 (JP)
(74) Representative: Bauch-Koepe, Katharina Anna
(86) International application number: PCT/JP2005/021579
(87) International publication number: WO 2006/057298

(57) **Abstract**

According to the invention, there is provided a polymerizable composition which is cured by irradiation with a small amount of energy line, and offers excellent adhesiveness and transparency. The composition comprises an acid generator (A) containing a sulfonium cation and a borate anion represented by the following general formula (1), and a cationic polymerizable compound (B).

General formula (1)

[BYₘZₙ]⁻ general formula(1)

Wherein, Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.

## Description

### Technical Field

The invention relates to a polymerizable composition comprising an acid generator and a cationic polymerizable compound. More specifically, the invention relates to an adhesive composition, a bonding adhesive, and an adhesive film using the same. Further, the invention relates to a sealing composition and a sealant. Further, the invention relates to an optical waveguide forming material and an optical waveguide.

### Background Art

Heretofore, polymerizable compositions have been used in various fields. Examples of the applications include adhesives. Adhesives have been used for circuit boards for semiconductor packages such as a ball grid array (BGA) package or a chip size package (CSP), and bonding between a tape automated bonding (TAB) tape and a heat spreader (heat sink). In these cases, an adhesive is used as a thermosetting liquid adhesive or an adhesive sheet. However, there has been a problem that semiconductor chips suffer heat stress if the adhesives are heated at high temperatures for a long time during curing. In terms of production, there has been another problem that the curing process of adhesives requires a long time. For example, formation of an adhesive sheet by heating at a temperature of 150°C for 2 hours during the curing process is described in Japanese Patent Application Laid-Open No. 2001-131499.

Further, conventional thermosetting adhesives have poor storage stability at room temperature, hence they must be shipped or stored at a low temperature. Further, they must be used in a short time. Thus, they give inconvenience in terms of facilities, costs, and handling. Further, if the curing temperature of an adhesive is set at a low temperature for reducing the curing time thereof, the storage stability of the adhesive deteriorates.

Further, conventional thermosetting die bonding films have large curing shrinkages during thermal curing. Hence, when a laminate is prepared by laminating a plurality of semiconductor chips via uncured die bonding films while aligning the chips, followed by heating the laminate to cure the bonding films, the laminated semiconductor chips may be misaligned each other or the semiconductor chips may be warped. This may cause displacement of the semiconductor chips.

Further, when a substrate having semiconductor devices is molded with a sealing resin, the die bonding films can be further shrunk by heat applied for curing the sealing resin, which may cause cracking in the sealing resin and semiconductor chips.

A photocuring die bonding film is disclosed in Japanese Patent Application Laid-Open No. 2004-39992. However, it has not achieved sufficient adhesive properties, and is expected to be further improved.
Under the circumstances, an adhesive composition which is cured by irradiation with a small amount of an active energy line, offers a cured article having excellent properties particularly in adhesiveness, and has excellent storage stability at room temperature has been desired. Also desired is an adhesive or an adhesive film which is capable of laminating semiconductor devices in parallel condition.

Further, other examples of the polymerizable compositions include sealants. Sealants are known to be used in optical devices, electronic devices, and optoelectronic devices. These devices are greatly affected by changes in ambient temperature and humidity. They are thus sealed with a liquid resin or the like, and used under protection from the external environment. In recent years, flip chip mounting for connecting bare chips directly to a printed circuit board is drawing attention as a method for mounting semiconductor chips. A process of melt-connecting metal bamp electrodes on the element forming surface of a bare chip with an electrode pad formed on a printed circuit board is disclosed in Japanese Patent Application Laid-Open Nos. 2003-238691 and 2003-277712. In this case, a sealant referred to as underfill sealant is used between the circuit board and the chip for stress reduction.

Further, sealants are used in liquid crystal displays. In a liquid crystal display, a liquid crystal is sealed between two parallel liquid crystal substrates, and a transparent electrode is laminated on the liquid crystal substrates. A sealant is used as the sealing material for sealing the liquid crystal. Heretofore, thermosetting epoxy resins have been used as the sealing material. However, such thermosetting epoxy resins requires heating at a high temperature from 150 to 180°C for about two hours, which hinders the increase of productivity.

Apart from such thermosetting system, in Japanese Patent Application Laid-Open Nos. 11-199651 and 2000-191751, ultraviolet curing sealing compositions are disclosed for the purposes of increasing productivity and sealing heat-sensitive base materials. However, they require large amount of irradiation energy for curing, and thus are expected to achieve further increase in productivity.

On the other hand, in an EL display, a sealant is used as a sealing material for bonding (sealing) a glass substrate and an airtight container which constitute the device. EL devices include inorganic EL devices and organic EL devices. Organic EL devices are superior to inorganic EL devices in high intensity, high efficiency, rapid response, and color variations. However, organic EL devices have low heat resistance, and their heat resistance temperature is about 80 to 100°C. Hence, sealing in an organic EL display cannot be thoroughly cured by thermal curing even though a thermosetting epoxy resin is used as a sealing material. A photocuring seal material which is capable of fast-curing at low temperatures is disclosed in Japanese Patent Application Laid-Open No. 2004-231938. However, irradiation with light having a wavelength of less than 350 nm during photoirradiation deteriorates organic dyes in an organic EL device, which results in insufficient luminescence intensity. Further, sufficient curability has not been achieved by irradiation with light having a wavelength of 350 nm or more.

Further, sealing of light emitting diodes with a resin is described in Japanese Patent Application Laid-Open No. 2004-221405. In particular a white LED is attracting attention as an illuminating light source which is capable of achieving remarkable energy saving. It is thus important to efficiently extract light emitted from a light emitting diode device (LED chip). Therefore, sealants for LED chips are desired to be colorless and have high transparency.

More specifically, a sealing composition which is cured by irradiation with a small amount of an active energy line, and has high transparency has been desired.
Examples of another polymerizable compositions include materials for forming optical waveguides. Optical waveguides are known as basic components of an optical device, optoelectronic integrated circuit (OEIC), and light integrated circuit (light IC) for achieving, for example, transfer of large volumes of information such as movies or moving images, and optical computers. Optical waveguides are now intensively studied to deal with the great demand for them, meanwhile high performance and low cost products are particularly demanded.

Heretofore, inorganic glass such as quartz has been known as such optical waveguides. Quartz-based optical waveguides have excellent properties such as heat resistance, low polarization plane dependence, low loss, and low temperature dependence. However, they cost much because they involves a high-temperature process and an RIE (Reactive Ion Etching) process.

On the other hand, in recent years, optical waveguides using polymer materials are supposed, and coming into practical use. Polymer materials are more easily processed in comparison with inorganic materials, which facilitates upsizing of film dimensions and formation of films. Further, they have various advantages such as a wide range of applications due to their flexibility, and easy adjustment of the refractive index. In particular, ultraviolet curing resins are material which can be produced on a large scale, hence they are expected as materials for optical waveguides.

As a method for forming an optical waveguide using a polymer material, a RIE method, stamper method (Japanese Patent Application Laid-Open No. 8-327844), direct exposure method, photo-bleaching method (Japanese Patent Application Laid-Open Nos. 2000-275456 and 2001-356227), and others are studied.

In the RIE method, in the first place, a thin film is formed, subsequently a resist is exposed to UV (ultraviolet light), and developed to form an waveguide pattern. In the next place, areas not covered with the resist are removed by reactive ion etching. Thereafter, the resist no longer in use is removed. The RIE method commonly costs much because it involves a vacuum process and a resist process during reactive ion etching. Further, reactive ion etching may generate minute vertical scratches (scratches in a thickness direction) on the side surface of the core, which results in the increase in scattering loss after formation of the optical waveguide.

In the stamper method, grooves are formed on a clad, subsequently a resin is poured into the grooves to form a core. This can achieve remarkable cost reduction. However, the stamper method cannot achieve sufficient waveguide efficiency due to occurrence of voids, burrs formed during forming the upper clad, and the like.

On the other hand, the direct exposure method involves no process of covering with a resist, and forms a pattern by irradiating with an energy line such as direct light, followed by removing unexposed areas by development. The method involves more simplified processes than the RIE method, which allows cost reduction.

Further, in the photo-bleaching method, an optical waveguide is formed just by irradiating with an active energy line such as light for making a refractive index difference. This eliminates the necessity of a photoresist application process, reactive ion etching process, and development process. It is thus a low-cost production method which offers excellent mass productivity, and reduces scattering loss due to fluctuations of side geometry which are seen in the RIE method and the stamper method.

An active energy line such as light emitted in the direct exposure method or the photo-bleaching method include various rays such as X rays, α rays, β rays, γ rays, ultraviolet rays, visible rays, infrared rays, and electron beams. Among them, it is most preferable to use an ultraviolet ray because it has a definite energy level and requires a relatively inexpensive and small irradiation device. Most common light sources include a high pressure mercury lamp, extra-high pressure mercury lamp, and metal halide lamp. When such a light source is used, light having a dominant wavelength in the wavelength region from 300 nm to 450 nm is to be emitted (UV EB Kokagijutsu no Genjo to Tenbo (Present State and Future Prospects of UV and EB Curing Technology), edited by RadTech Japan, published by CMC Inc. (2002)). In recent years, in the field of optical waveguides, universally demanded is a material which is compatible with above light sources, rapidly cures to a desired degree of polymerization, and exhibits favorable characteristics.

More specifically, heretofore a material for forming an optical waveguide has been demanded, which is cured by irradiation with a small amount of an active energy line, and thus requires low cost and offers excellent mass productivity.

### Disclosure of the Invention

One embodiment of the invention relates to a polymerizable composition comprising an acid generator (A) containing a sulfonium cation and a borate anion represented by the following general formula (1):

[BYₘZₙ]⁻ general formula(1)

(wherein Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.), and a cationic polymerizable compound (B).
The polymerizable composition of the invention (hereinafter referred to as composition) may be used as an adhesive composition, sealing composition and optical waveguide forming material.
One embodiment of the invention relates to an adhesive composition comprising an acid generator (A) containing a sulfonium cation and a borate anion represented by the following general formula (1), and having a molar extinction coefficient in the range from 3000 to 25000 at a wavelength of 350 nm in acetonitrile, and a cationic polymerizable compound (B).

[BYₘZₙ]⁻ general formula (1)

(wherein Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.)

The sulfonium cation is preferably represented by the general formula (2).

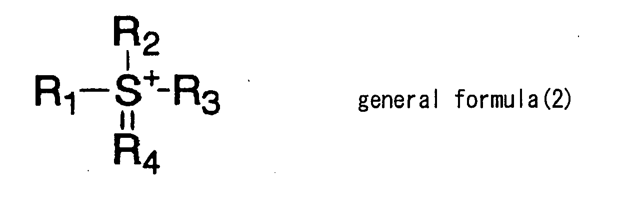

(wherein R₁ is a group selected from a substituted benzyl group, substituted phenacyl group, substituted allyl group, substituted alkoxyl group, substituted aryloxy group and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, and R₄ represents an oxygen atom or a lone pair. Further, two or more of R₁, R₂, and R₃ may be bonded to form a cyclic structure.)

The cationic polymerizable compound is preferably a compound having within the molecule thereof at least one epoxy group or at least one oxetanyl group.

One embodiment of the invention relates to a die bonding adhesive containing the above-described adhesive composition.

One embodiment of the invention relates to a die bonding adhesive film obtained by applying the adhesive to a base material.

One embodiment of the invention relates to a process for producing a bonded article formed by bonding a semiconductor device to a supporting member, wherein a layer containing the adhesive is formed between the semiconductor device and the supporting member, and the adhesive or adhesive film is cured by irradiation with light containing at least a portion of rays having a wavelength from 350 nm to 450 nm.

One embodiment of the invention relates to a process for producing a bonded article formed by bonding a semiconductor device to a supporting member, wherein a layer containing the adhesive is formed on the surface of the semiconductor device to be bonded to the supporting member, and laminated onto the supporting member after irradiation with light containing at least a portion of rays having a wavelength from 350 nm to 450 nm.

The adhesive composition according to one embodiment of the invention is cured by irradiation with a small amount of an active energy line, and offers high heat resistance, durability, transparency, and adhesion strength after crosslinking curing by the energy line. Further, the adhesive composition according to one embodiment of the invention comprises the acid generator (A), hence it efficiently generates a very strong acid even by irradiation with a small amount of an energy line. This allows the reduction of the irradiation time of an active energy line to improve processability, and the reduction of deterioration of the base material due to energy line irradiation. The adhesive composition of the invention is particularly useful as an adhesive for die bonding applications.

Further, one embodiment of the invention relates to a sealing composition comprising an acid generator (A) containing a sulfonium cation and a borate anion represented by the following general formula (1) and having a molar extinction coefficient in the range from 3000 to 25000 at a wavelength of 350 nm, and a cationic polymerizable compound (B).

[BYₘZₙ]⁻ general formula (1)

(wherein Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.)

The sulfonium cation is preferably represented by the general formula (2).

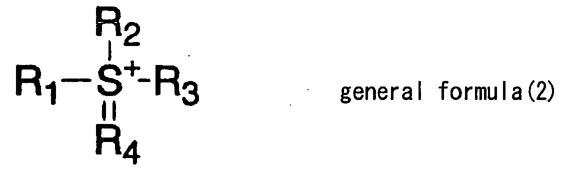

(wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, and R₄ represents an oxygen atom or a lone pair. Further, two or more of R₁, R₂, and R₃ may be bonded to form a cyclic structure.)

The cationic polymerizable compound is preferably a compound having within the molecule thereof at least one epoxy group or at least one oxetanyl group.

One embodiment of the invention relates to a sealant containing the sealing composition.

One embodiment of the invention relates to a process for producing a sealed article, wherein the sealant is applied to or charged into a part of or all over a base material, and irradiated with light containing at least a portion of rays having a wavelength from 350 nm to 450 nm to cure the sealant.

One embodiment of the invention relates to a process for sealing a base material, wherein the sealant is applied to or charged into a part of or all over the base material, and irradiated with light containing at least a portion of rays having a wavelength from 350 nm to 450 nm to cure the sealant.

The sealing composition according to one embodiment of the invention is cured by irradiation with a small amount of an active energy line, and offers high heat resistance, durability, transparency, and adhesion strength after crosslinking curing by the energy line. Further, the sealing composition of the invention according to one embodiment of the invention comprises the acid generator (A), hence it rapidly promotes cation polymerization to a desired degree of polymerization by irradiation with an energy line, and thus offers high processability and adhesiveness. Further, it efficiently generates a very strong acid even by irradiation with a small amount of an energy line, which allows the reduction of the irradiation time of an active energy line to improve processability, and the reduction of deterioration of base materials due to energy line irradiation. The sealing composition of the invention is useful for sealing various devices.
Further, one embodiment of the invention relates to an optical waveguide forming material comprising an acid generator (A) containing a sulfonium cation and a borate anion represented by the following general formula (1) and having a molar extinction coefficient in the range from 500 to 25000 at a wavelength of 365 nm, and a cationic polymerizable compound (B).

[BY ₘZₙ]⁻ general formula (1)

(wherein Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.)

The sulfonium cation is preferably represented by the general formula (2).

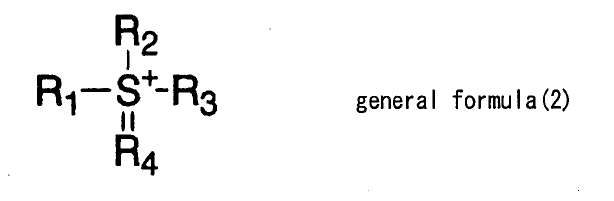

(wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, and R₄ represents an oxygen atom or a lone pair. Further, two or more of R₁, R₂, and R₃ may be bonded to form a cyclic structure.)

The cationic polymerizable compound (B) is preferably a compound having within the molecule thereof at least one epoxy group or at least one oxetanyl group, or a hydrolysate of a hydrolysable silane compound.

One embodiment of the invention relates to an optical waveguide formed by curing the optical waveguide forming material.

One embodiment of the invention relates to a process for producing an optical waveguide having a core and a clad layer, wherein the optical waveguide forming material is applied to a substrate such that it forms at least either a core or a clad layer, and then cured by photoirradiation.

One embodiment of the invention relates to an optical waveguide produced by said process for producing an optical waveguide.

The optical waveguide forming material according to one embodiment of the invention contains the specific acid generator (A), hence it is very easily cured in a short time by irradiation with a small amount of an active energy line. Further, the optical waveguide forming material according to one embodiment of the invention permits patternwise exposure, or the refractive index thereof can be changed by irradiation with an active energy line, which facilitates the formation of an optical waveguide. The optical waveguide forming material according to one embodiment of the invention may be used for producing optical waveguides at low cost and with excellent mass productivity.
The present disclosure relates to subject matter contained in Japanese Patent Application Nos. 2005-177454 filed on June 17, 2005, 2004-341597 filed on November 26, 2004, and 2004-357990 filed on December 10, 2004, the disclosure of which is expressly incorporated herein by reference in its entirety.

### [Brief Description of the Drawings]

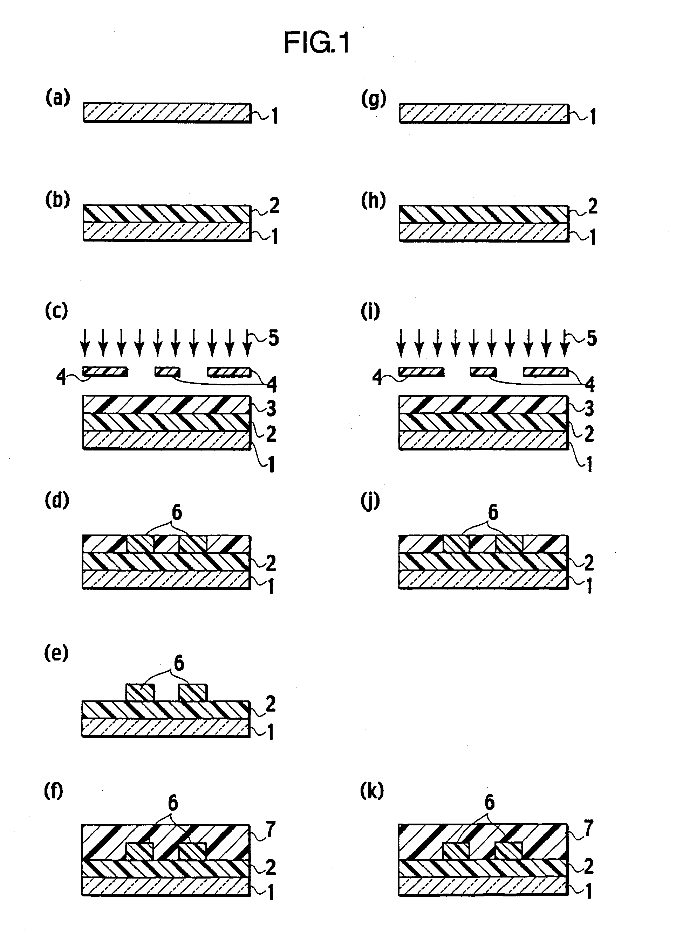

[Fig. 1] Fig. 1 represents partial flow sheets of processes for producing optical waveguides. (a) through (f) represent a partial flow sheet of production by the direct exposure method. (g) through (k) represent a partial flow sheet of production by the photo-bleaching method.

### [Best Mode for Carrying Out The Invention]

Embodiments of the invention are described in detail below.

### [Acid generator (A)]

In the first place, the acid generator (A) used in the invention is described. The acid generator (A) used in the invention is a material generating an acid by irradiation with an energy line. The acid generated from the acid generator initiates and promotes crosslinking of the cationic polymerizable compound (B) by cation polymerization.

The acid generator (A) used in the invention is adjusted such that the molar extinction coefficient thereof at a wavelength of 350 nm falls within a range from 3000 to 25000, when it is used as an adhesive composition or a sealant composition. This achieves remarkable improvement in sensitivity to an energy line, particularly to photoirradiation in the wavelength region from 350 nm to 450 nm. Accordingly, the acid generator (A) of the invention can be used with no sensitizer. Even if a sensitizer is concurrently used, the amount thereof can be minimized, which allows to maintain high transparency of the present composition.
For the sake of adjusting the acid generator (A) such that the molar extinction coefficient thereof at a wavelength of 350 nm falls within a range from 3000 to 25000, it may have, at the sulfonium cation site thereof, for example, a specific structure represented by the general formula (2).

When used as an optical waveguide forming material, the acid generator (A) used in the invention is adjusted such that the molar extinction coefficient at a wavelength of 365 nm falls within the range from 500 to 25000. This achieves remarkable improvement in sensitivity to an energy line, particularly to photoirradiation in the wavelength region from 350 nm to 450 nm. Accordingly, the acid generator (A) of the invention may be used alone. Further, even when a sensitizer is concurrently used, the amount thereof can be minimized, which allows to maintain high transparency of the optical waveguide forming material of the invention.
For the sake of adjusting the acid generator (A) such that the molar extinction coefficient thereof at a wavelength of 365 nm falls within a range from 500 to 25000, it may have, at the sulfonium cation site thereof, for example, a specific structure represented by the general formula (2).

In an adhesive composition, in case that the acid generator (A) of the invention has a molar extinction coefficient of less than 3000 at a wavelength of 350 nm, it cannot generate a sufficient amount of acid by photoirradiation in the wavelength region, which may cause insufficient curing of the adhesive composition of the invention. Further, in case that the acid generator (A) has a molar extinction coefficient of exceeding 25000 at a wavelength of 350 nm, the acid generator (A) exhibits deteriorated stability to light, which may also deteriorate the storage stability of the adhesive composition itself.

In a sealing composition, in case that the acid generator (A) of the invention has a molar extinction coefficient of less than 3000 at a wavelength of 350 nm, it cannot generate a sufficient amount of acid by photoirradiation in the wavelength region, which may cause insufficient curing of the sealing composition of the invention. Further, in case that the acid generator (A) has a molar extinction coefficient of exceeding 25000 at a wavelength of 350 nm, coloring due to the acid generator (A) may hinder the sealing composition of the invention from maintaining high transparency.

In an optical waveguide forming material, in case that the acid generator (A) of the invention has a molar extinction coefficient of less than 500 at a wavelength of 365 nm, it cannot generate a sufficient amount of acid by photoirradiation in the wavelength region, which may cause insufficient curing of the optical waveguide forming material of the invention. Further, in case that the acid generator (A) has a molar extinction coefficient of exceeding 25000 at a wavelength of 365 nm, coloring due to the acid generator (A) may occur, and insufficient transmission of irradiated light may hinder the generation of sufficient amounts of light in the deepest portion, which may cause insufficient curing of the optical waveguide forming material of the invention.
The molar extinction coefficient is calculated from the measurement for the acid generator (A) dissolved in acetonitrile at 25°C.

An energy line source for generating an acid from the acid generator (A) used in the invention is not particularly limited. However, the light source is preferably capable of emitting light in the wavelength region from 350 nm to 450 nm which exhibits particularly suitable sensitivity. Further, the energy line source may emit another energy line concomitantly with the emission of light in said wavelength region. Particularly preferable light sources include a light source having a dominant emission wavelength in the wavelength region from 350 nm to 450 nm. Specific examples include, but not limited to, an ultrahigh pressure mercury lamp, high pressure mercury lamp, mercury xenon lamp, metal halide lamp, high power metal halide lamp, xenon lamp, and pulse luminescence xenon lamp. Also useful as a suitable energy line source are lasers having an emission wavelength in the wavelength region from 350 nm to 450 nm, such as a Nd-YAG third harmonic laser, He-Cd laser, nitrogen laser, Xe-Cl excimer laser, Xe-F excimer laser, and semiconductor excited solid-state laser. Further, electron beams are also useful as a suitable energy line source. The acid generators of the invention have a suitable absorption in the wavelength region from 350 nm to 450 nm. The absorption properties of the acid generator (A) vary to some extent depending on the substituents thereof. However, said light sources selected as appropriate are capable of serving as an acid generator having very high sensitivity to energy lines. Further, as appropriate, light from above light sources may be emitted through an optical instrument such as a filter, mirror, and lens.

In the next place, the acid generator (A) used in the invention is described in detail as to its structure.

The acid generator (A) used in the invention is an onium salt type acid generator comprising a sulfonium cation and a borate anion represented by the general formula (1). A sulfonium cation has a high reduction potential, or has high electronic acceptability. Hence, it is decomposed by irradiation with an energy line, particularly by photoirradiation, to readily generate an acid.

Examples of particularly preferable structures of sulfonium cations include a sulfonium cation represented by the general formula (2).

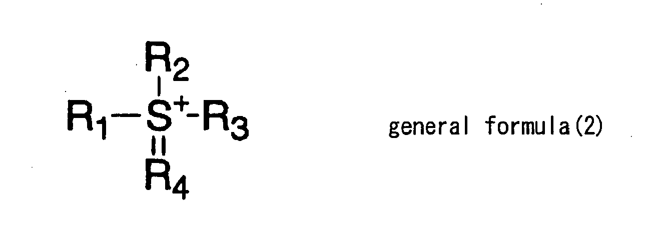

(wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, and R₄ represents an oxygen atom or a lone pair. Further, two or more of R_{1,} R₂, and R₃ may be bonded to form a cyclic structure.)

The substituent R₁ is characterized by being substituted, and specifically has a structure selected from the general formula (3) through general formula (6).

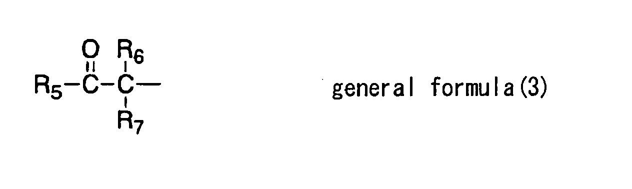

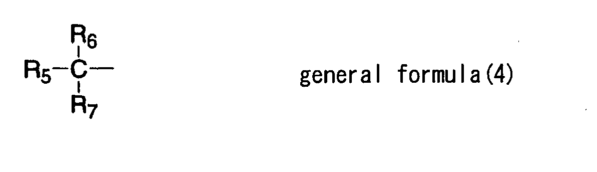

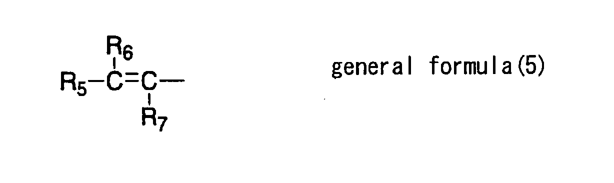

R₅-O- general formula (6)

R₅ is, common to the general formulae (3) through (6), selected from a monocyclic or condensed polycyclic aryl ring having 6 to 24 carbon atoms, substituted monocyclic or condensed polycyclic aryl group having 6 to 24 carbon atoms, monocyclic or condensed polycyclic heterocyclic group having 4 to 24 carbon atoms, and substituted monocyclic or condensed polycyclic heterocyclic group having 4 to 24 carbon atoms. For the general formula (6), R₅ may also be selected from an alkyl group and substituted alkyl group, wherein a below-described substituent is required for absorbing rays in a wavelength region from 350 nm to 450 nm.
R₆ and R₇ are, common to the general formulae (3) through (5), each independently represent a hydrogen atom, alkyl group, substituted alkyl group, aryl group, substituted aryl group, heterocyclic group, substituted heterocyclic group, alkoxyl group, substituted alkoxyl group, aryloxy group, substituted aryloxy group, heterocyclic oxy group, substituted heterocyclic oxy group, alkenyl group, or substituted alkenyl group. R₅, R₆, and R₇ may be unified to form a ring.

Specific examples of said monocyclic or condensed polycyclic aryl groups having 6 to 24 carbon atoms include, but not limited to, a phenyl group, 1-naphthyl group, 2-naphthyl group, 1-anthryl group, 9-anthryl group, 2-phenanthryl group, 3-phenanthryl group, 9-phenanthryl group, 1-pyrenyl group, 5-naphthasenyl group, 1-indenyl group, 2-azulenyl group, 1-acenaphthyl group, 2-fluorenyl group, 9-fluorenyl group, 3-perylenyl group, o-tolyl group, m-tolyl group, p-tolyl group, 2,3-xylyl group, 2,5-xylyl group, mesityl group, p-cumenyl group, p-dodecylphenyl group, p-cyclohexylphenyl group, 4-biphenyl group, o-fluorophenyl group, m-chlorophenyl group, p-bromophenyl group, p-hydroxyphenyl group, m-carboxyphenyl group, o-mercaptophenyl group, p-cyanophenyl group, m-nitrophenyl group, and m-azidophenyl group. Further, the substituent R₅ in the general formulae (3) through (6) may be bonded to a carbon atom in the general formulae (3) through (5), and an oxygen atom in the general formula (6) at a substitution site other than those described above, and these are also included in the substituent represented by R₅ in the invention.

Examples of said monocyclic or condensed polycyclic heterocyclic group having 4 to 24 carbon atoms include those having a nitrogen atom, oxygen atom, sulfur atom, or phosphorus atom. Specific examples thereof include, but not limited to, 2-thienyl group, 2-benzothienyl group, naphtho-[2,3-b]thienyl group, 3-thianthrenyl group, 2-thianthrenyl group, 2-furyl group, 2-benzofuryl group, pyranyl group, isobenzofuranyl group, chromenyl group, xanthenyl group, phenoxathiinyl group, 2H-pyrrolyl group, pyrrolyl group, imidazolyl group, pyrazolyl group, pyridyl group, pyrazinyl group, pyrimidinylgroup, pyridazinyl group, indolizinyl group, isoindolyl group, 3H-indolyl group, 2-indolyl group, 3-indolyl group, 1 H-indazolyl group, purinyl group, 4H-quinolizinyl group, isoquinolyl group, quinolyl group, phthalazinyl group, naphthyridinyl group, quinoxanilyl group, quinazolinyl group, cinnolinyl group, pteridinyl group, 4aH-carbazolyl group, 2-carbazolyl group, 3-carbazolyl group, β-carbolinyl group, phenantridinyl group, 2-acridinyl group, perimidinyl group, phenanthrolinyl group, phenazinyl group, phenarsadinyl group, isothiazolyl group, phenothiadinyl group, isoxazolylgroup, furazanyl group, 3-phenoxazinyl group, isochromanyl group, chromanyl group, pyrrolidinyl group, pyrrolinyl group, imidazolidinyl group, imidazolinyl group, pirazolidinyl group, pirazolinyl group, piperidyl group, piperadinyl group, indolinyl group, isoindolinyl group, quinuclidinyl group, morpholinyl group, thioxanetolyl group, 4-quinolinyl group, 4-isoquinolyl group, 3-phenothiadinyl group, 2-phenoxathiinyl group, and 3-coumarinyl group. Further, the substituent R₅ in the general formulae (3) through (6) may be bonded to a carbon atom in the general formulae (3) through (5), and an oxygen atom in the general formula (6) at a substitution site other than those described above, and these are also included in the substituent represented by R₅ in the invention.

Among them, examples of more preferable monocyclic or condensed polycyclic aryl group having 6 to 24 carbon atoms, or monocyclic or condensed polycyclic heterocyclic group having 4 to 24 carbon atoms include structures selected from the general formulae (7) through (10).

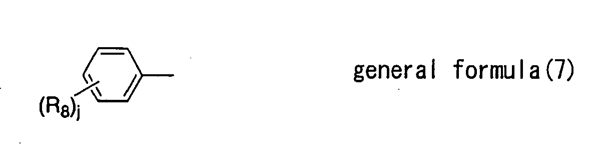

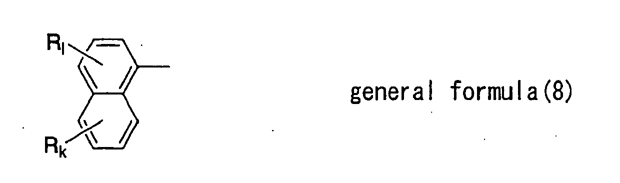

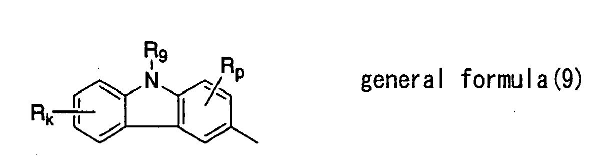

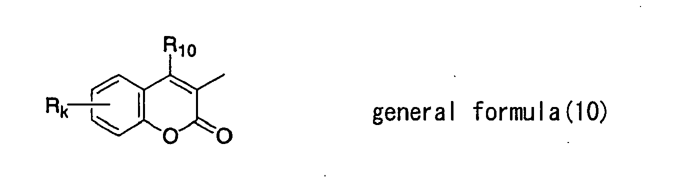

R₈ each independently represents a group selected from an alkyl group, aryl group, heterocyclic group, alkylthio group, arylthio group, heterocyclic thio group, acyl group, alkoxyl group, aryloxy group, and heterocyclic oxy group, and substituted derivatives thereof, and a halogen atom. R₉ represents a group selected from an alkyl group, aryl group, heterocyclic group, acyl group, and alkenyl group, and substituted derivatives thereof. R (R of Rₖ, Rₗ, and Rₚ) each independently represents a group selected from an alkyl group, aryl group, heterocyclic group, alkenyl group, acyl group, alkoxyl group, aryloxy group, heterocyclic oxy group, alkylthio group, arylthio group, heterocyclic thio group and acyloxy group, and substituted derivatives thereof, and a halogen atom. j, k, l, and p represent a number of substitution of the substitute R₈ or R. j represents an integer from 1 to 5. k represents an integer from 0 to 4. I represents an integer from 0 to 3, and p represents an integer from 0 to 3. k+l must be 1 or more. Further, adjacent Rs, R₈s, or R and R₉, and R and R₁₀ may be covalently bonded to form a ring structure. In the general formulae (8) through (10), they may be bonded to a carbon atom in the general formulae (3) through (5), or an oxygen atom in the general formula (6) at a substitution site other than those described above.

Further, the acid generator (A) used in the invention has a substituent for absorbing light in the wavelength region from 350 nm to 450 nm. Preferable examples of such a substituent include an aryl group, heterocyclic group, alkylthio group, arylthio group, heterocyclic thio group, alkoxyl group, aryloxy group, heterocyclic oxy group, and acyl group.

The various substituents described above are further illustrated below.
Examples of alkyl group include a straight, branched, monocyclic, or condensed polycyclic alkyl group having 1 to 18 carbon atoms. Specific examples thereof include, but not limited to, a methyl group, ethyl group, propyl group, butyl group, pentyl group, hexyl group, heptyl group, octyl group, nonyl group, decyl group, dodecyl group, octadecyl group, isopropyl group, isobutyl group, isopentyl group, sec-butyl group, t-butyl group, sec-pentyl group, t-pentyl group, t-octyl group, neopentyl group, cyclopropyl group, cyclobutyl group, cyclopentyl group, cyclohexyl group, adamantyl group, norbornyl group, bornyl group, and 4-decylcyclohexyl group.

Examples of aryl group include, but not limited to, the same substituent as those exemplified as an aryl group for the substituent R₅. The substituent R₅ in the general formulae (3) through (6), the substituent R₆ in the general formulae (3) through (6), the substituent R₇ in the general formulae (3) through (6), the substituent R₈ in the general formula (7), the substituent R in the general formulae (8) through (10), and the substituent R₁₀ in the general formula (10) may be bonded to a carbon atom in the general formulae (3) through (5) and (7) through (10), and an oxygen atom in the general formula (6) at a substitution site other than those described above. Further, the substituent R₉ in the general formula (9) may be bonded to a carbon atom at a substitution site other than those described above. These are also included in the substituents represented by R₅ , R₆, R₇, R₈, R₉, R, and R₁₀ in the invention.

Examples of heterocyclic group include, but not limited to, the same substituent as those exemplified as a heterocyclic group for the substituent R₅. The substituent R₅ in the general formulae (3) through (6), the substituent R₆ in the general formulae (3) through (6), the substituent R₇ in the general formulae (3) through (6), the substituent R₈ in the general formula (7), the substituent R in the general formulae (8) through (10), and the substituent R₁₀ in the general formula (10) may be bonded to a carbon atom in the general formulae (3) through (5) and (7) through (10), and an oxygen atom in the general formula (6) at a substitution site other than those described above. Further, the substituent R₉ in the general formula (9) may be bonded to a carbon atom at a substitution site other than those described above. These are also included in the substituents represented by R₅ , R₆, R₇, R₈, R₉, R, and R₁₀ in the invention.

Examples of alkenyl group include a straight, branched, monocyclic, or condensed polycyclic alkenyl group having 1 to 18 carbon atoms, and these may have a plurality of carbon-carbon double bonds within the structure thereof. Specific examples thereof include, but not limited to, a vinyl group, 1-propenyl group, allyl group, 2-butenyl group, 3-butenyl group, isopropenyl group, isobutenyl group, 1-pentenyl group, 2-pentenyl group, 3-pentenyl group, 4-pentenyl group, 1-hexenyl group, 2-hexenyl group, 3-hexenyl group, 4-hexenyl group, 5-hexenyl group, cyclopentenyl group, cyclohexenyl group, 1,3-butadienyl group, cyclohexadienyl group, and cyclopentadienyl group.

Examples of alkoxyl group include a straight, branched, monocyclic, or condensed polycyclic alkoxyl group having 1 to 18 carbon atoms. Specific examples thereof include, but not limited to, a methoxy group, ethoxy group, propoxy group, butoxy group, pentyloxy group, hexyloxy group, heptyl oxy group, octyloxy group, nonyloxy group, decyloxy group, dodecyloxy group, octadecyloxy group, isopropoxy group, isobutoxy group, isopentyloxy group, sec-butoxy group, t-butoxy group, sec-pentyloxy group, t-pentyloxy group, t-octyloxy group, neopentyloxy group, cyclopropyloxy group, cyclobutyloxy group, cyclopentyloxy group, cyclohexyloxy group, adamantyloxy group, norbornyloxy group, bornyloxy group, 4-decylcyclohexyloxy group, 2-tetrahydrofuranyloxy group, and 2-tetrahydropyranyloxy group.

Examples of aryloxy group include monocyclic or condensed polycyclic aryloxy groups having 6 to 18 carbon atoms. Specific examples thereof include, but not limited to, a phenoxy group, 1-naphthyloxy group, 2-naphthyloxy group, 9-anthryloxy group, 9-phenanthryloxy group, 1-pyrenyloxy group, 5-naphthasenyloxy group, 1-indenyloxy group, 2-azulenyloxy group, 1-acenaphthyloxy group, and 9-fluorenyloxy group. The aryl group may be bonded to an oxygen atom at a site other than those described above, and these are also included in the substituents represented by R₁, R₂, R₃, R₆, R₇, R₈, R, and R₁₀ in the invention.

Examples of heterocyclicoxy group include a monocyclic or condensed polycyclic heterocyclicoxy group having 4 to 18 carbon atoms containing an atom selected from a nitrogen atom, oxygen atom, sulfur atom, and phosphorus atom. Specific examples thereof include, but not limited to, a 2-furanyloxy group, 2-thienyloxy group, 2-indolyloxy group, 3-indolyloxy group, 2-benzofuryloxy group, 2-benzothienyloxy group, 2-carbazolyloxy group, 3-carbazolyloxy group, 4-carbazolyloxy group, and 9-acridinyloxy group. The heterocyclic group may be bonded to an oxygen atom at a site other than those described above, and these are also included in the substituents represented by R₁, R₂, R₃, R₆, R₇, R₈, R, and R₁₀ in the invention.

Examples of acyl group include a carbonyl group bonded to a hydrogen atom or a straight, branched, monocyclic, or condensed polycyclic aliphatic group having 1 to 18 carbon atoms, a carbonyl group bonded to a monocyclic or condensed polycyclic aryl group having 6 to 18 carbon atoms, and a carbonyl group bonded to a monocyclic or condensed polycyclic heterocyclic group having 4 to 18 carbon atoms containing an atom selected from a nitrogen atom, oxygen atom, sulfur atom, and phosphorus atom. Specific examples thereof include, but not limited to, a formyl group, acetyl group, propionyl group, butyryl group, isobutyryl group, valeryl group, isovaleryl group, pivaloyl group, lauroyl group, myristoyl group, palmitoyl group, stearoyl group, cyclopentyl carbonyl group, cyclohexyl carbonyl group, acryloyl group, methacryloyl group, crotonoyl group, isocrotonoyl group, oleoyl group, cinnamoyl group, benzoyl group, 1-naphthoyl group, 2-naphthoyl group, 9-anthrylcarbonyl group, 3-furoyl group, 2-thenoyl group, nicotinoyl group, and isonicotinoyl group. The aryl group and carbonyl group, heterocyclic group and carbonyl group may be each bonded together at a site other than those described above, and these are included in the substituents represented by R₈, R₉, and, R in the invention.

Examples of alkylthio group include a straight, branched, monocyclic, or condensed polycyclic alkylthio group having 1 to 18 carbon atoms. Specific examples thereof include, but not limited to, a methylthio group, ethylthio group, propylthio group, butylthio group, pentylthio group, hexylthio group, octylthio group, decylthio group, dodecylthio group, and octadecylthio group.

Examples of arylthio group include a monocyclic or condensed polycyclic arylthio group having 4 to 18 carbon atoms. Specific examples thereof include, but not limited to, a phenylthio group, 1-naphthylthio group, 2-naphthylthio group, 9-anthrylthio group, and 9-phenanthrylthio group. The aryl group may be bonded to a sulfur atom at a site other than those described above, and these are also included in the substituents represented by R₈ and R in the invention.

Examples of heterocyclic thio group include a monocyclic or condensed polycyclic heterocyclic thio group containing an atom selected from a nitrogen atom, oxygen atom, sulfur atom, and phosphorus atom and having 4 to 18 carbon atoms. Specific examples thereof include, but not limited to, a 2-furylthio group, 2-thienylthio group, 2-pyrrolylthio group, 6-indolylthio group, 2-benzofurylthio group, 2-benzothienylthio group, 2-carbazolylthio group, 3-carbazolylthio group, and 4-carbazolylthio group. The heterocyclic group may be bonded to a sulfur atom at a site other than those described above, and these are also included in the substituents represented by R₈ and R in the invention.

Examples of acyloxy group include a carbonyloxy group bonded to a hydrogen atom or a straight, branched, monocyclic, or condensed polycyclic aliphatic group having 1 to 18 carbon atom, a carbonyloxy group bonded to a monocyclic or condensed aryl group having 6 to 18 carbon atoms, and a carbonyloxy group bonded to a monocyclic or condensed polycyclic heterocyclic group having 4 to 18 carbon atoms containing an atom selected from a nitrogen atom, oxygen atom, sulfur atom, and phosphorus atom. Specific examples thereof include, but not limited to, an acetoxy group, propionyloxy group, butyryloxy group, isobutyryloxy group, valeryloxy group, isovaleryloxy group, pivaloyloxy group, lauroyloxy group, myristoyloxy group, palmitoyloxy group, stearoyloxy group, cyclopentyl carbonyloxy group, cyclohexylcarbonyloxy group, acryloyloxy group, methacryloyloxy group, crotonoyloxy group, isocrotonoyloxy group, oleoyloxy group, benzoyloxy group, 1-naphthoyloxy group, 2-naphthoyloxy group, cinnamoyloxy group, 3-furoyloxy group, 2-thenoyloxy group, nicotinoyloxy group, isonicotinoyloxy group, 9-anthroyloxy group, and 5-naphthacenoyloxy group. The aryl group and carbonyloxy group, heterocyclic group and carbonyloxy group may be each bonded together at a site other than those described above, and these are also included in the substituents represented by R in the invention.

Examples of halogen atom include fluorine, chlorine, bromine, and iodine.

In the general formulae (2) through (10), the alkyl group, aryl group, heterocyclic group, alkoxyl group, aryloxy group, heterocyclicoxy group, alkenyl group, alkylthio group, arylthio group, heterocyclic thio group, acyl group, and acyloxy group may be further substituted with another substituent. Examples of another substituent include a hydroxyl group, mercapto group, cyano group, nitro group, halogen atom, alkyl group, aryl group, heterocyclic group, acyl group, alkoxyl group, aryloxy group, heterocyclicoxy group, acyloxy group, alkylthio group, arylthio group, and heterocyclic thio group.
Examples of aryl group as another substituent include a monocyclic or condensed polycyclic aryl group having 6 to 18 carbon atoms, and specific examples thereof include, but not limited to, a phenyl group, 1-naphthyl group, 2-naphthyl group, 9-anthryl group, 9-phenanthryl group, 1-pyrenyl group, 5-naphthasenyl group, 1-indenyl group, 2-azulenyl group, 1-acenaphthyl group, and 9-fluorenyl group.
Examples of heterocyclic group as another substituent include a monocyclic or condensed polycyclic heterocyclic group containing an atom selected from a nitrogen atom, oxygen atom, sulfur atom and phosphorus atom and having 4 to 18 carbon atoms. Specific examples thereof include, but not limited to, a 2-furanyl group, 2-thienyl group, 2-indolyl group, 3-indolyl group, 2-benzofuryl group, 2-benzothienyl group, 2-carbazolyl group, 3-carbazolyl group, 4-carbazolyl group, and 9-acridinyl group.
Examples of acyl group as another substituent include a carbonyl group bonded to a hydrogen atom or a straight, branched, monocyclic, or condensed polycyclic aliphatic having 1 to 18 carbon atoms, a carbonyl group bonded to a monocyclic or condensed polycyclic aryl group having 6 to 18 carbon atoms, and a carbonyl group bonded to a monocyclic or condensed polycyclic heterocyclic group having 4 to 18 carbon atoms and containing an atom selected from a nitrogen atom, oxygen atom, sulfur atom, and phosphorus atom, and these may have a unsaturated bond within the structure thereof. Specific examples thereof include a formyl group, acetyl group, propionyl group, butyryl group, isobutyryl group, valeryl group, isovaleryl group, pivaloyl group, lauroyl group, myristoyl group, palmitoyl group, stearoyl group, cyclopentyl carbonyl group, cyclohexylcarbonyl group, acryloyl group, methacryloyl group, crotonoyl group, isocrotonoyl group, oleoyl group, benzoyl group, 2-methyl benzoyl group, 4-methoxy benzoyl group, 1-naphthoyl group, 2-naphthoyl group, cinnamoyl group, 3-furoyl group, 2-thenoyl group, nicotinoyl group, isonicotinoyl group, 9-anthroyl group, and 5-naphthacenoyl group.
Examples of halogen atom, alkyl group, alkoxyl group, aryloxy group, heterocyclicoxy group, acyloxy group, alkylthio group, arylthio group, and heterocyclic thio group as another substituent are the same as those described above in the present description.

The substituent R₂ may be bonded to any of R₆, R₇, R₈, R₉, R₁₀, and R through a divalent organic residue to form a ring structure. Further, the substituent R₆ and R₇ may be bonded to any of R₈, R₉, R₁₀, and R through a divalent organic residue to form a ring structure. The above-described divalent organic residue refers to an alkylene group which may have a substituent having 1 to 4 carbon atoms, arylene group which may have a substituent, arylalkylene group, or alkylene group which may contain -C=C-, -O-, -S-, -NH-, -SO₂- -CO-, -COO-, -OCOO-, -CONH-, -SO₂-O-, or a substituent partially having these bonds.

In the next place, the borate anion for constituting the acid generator (A) used in the invention is further described.

The borate anion for constituting the acid generator (A) used in the invention is represented by the following general formula (1).

[BYₘZₙ]⁻ general formula(1)

(wherein Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4.)
Examples of the substituent Z in the general formula (1) include, but not limited to, a 3,5-difluorophenyl group, 2,4,6-trifluorophenyl group, 2,3,4,6-tetrafluorophenyl group, penta fluorophenyl group, 2,4-bis(trifluoromethyl)phenyl group, 3,5-bis(trifluoromethyl)phenyl group, 2,4,6-trifluoro-3,5-bis(trifluoromethyl)phenyl group, 3,5-dinitrophenyl group, 2,4,6-trifluoro-3,5-dinitrophenyl group, 2,4-dicyanophenyl group, 4-cyano-3,5-dinitrophenyl group, and 4-cyano-2,6-bis(trifluoromethyl)phenyl group.

Accordingly, specific examples of the structure of borate anion represented by the general formula (1) include pentafluorophenyl trifluoroborate, 3,5-bis(trifluoromethyl)phenyl trifluoroborate, bis(pentafluorophenyl) difluoroborate, bis[3,5-bis(trifluoromethyl)phenyl] difluoroborate, tris(pentafluorophenyl) fluoroborate, tris[3,5-bis(trifluoromethyl)phenyl] fluoroborate, tetrakis(pentafluorophenyl) borate, and tetrakis[3,5-bis(trifluoromethyl)phenyl] borate.

Among them, particularly preferable anions represented by the general formula (1) are tetrakis(pentafluorophenyl) borate and tetrakis [3,5-bis(trifluoromethyl)phenyl] borate.

The reasons for this include that they are relatively readily synthesized, generate a very strong acid, and exhibit high solubility, and offer high safety and hygiene.

The acid generator (A) used in the invention comprises a combination of a sulfonium cation and a borate anion exemplified above.

Specific examples of the structure are listed below, but the structure of the acid generator of the invention is not limited to them.

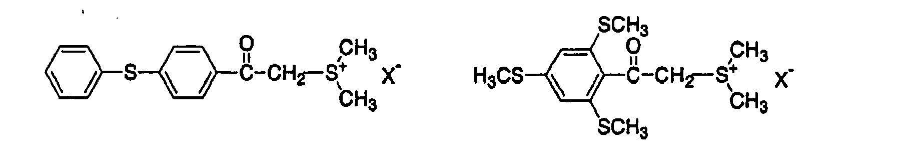

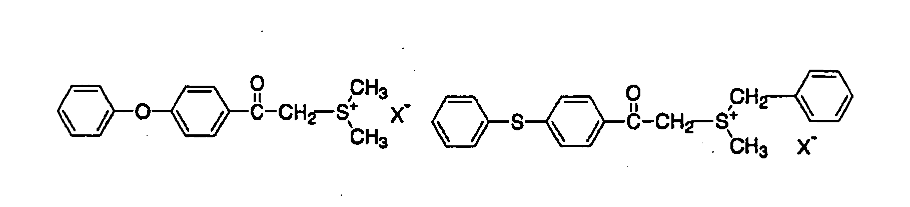

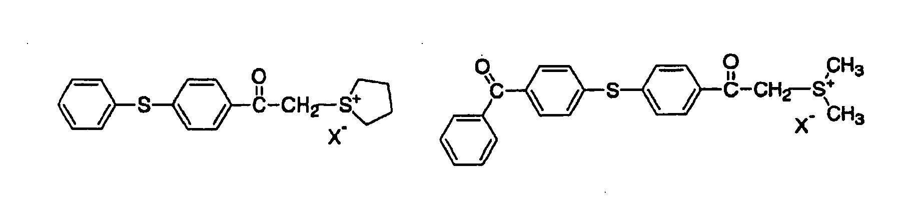

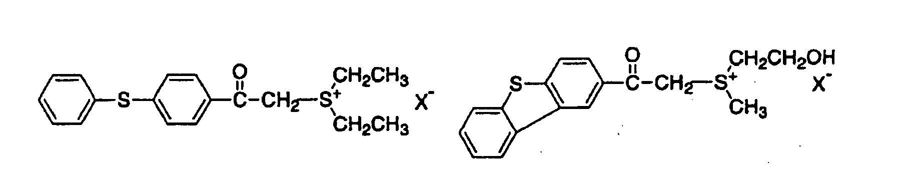

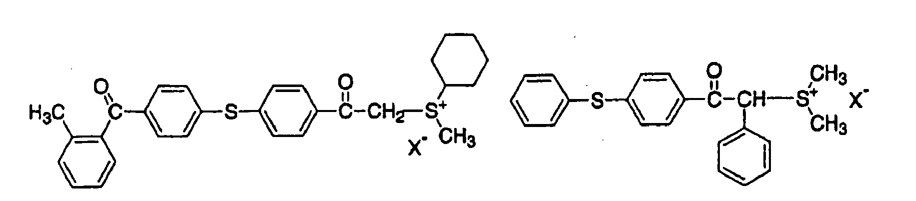

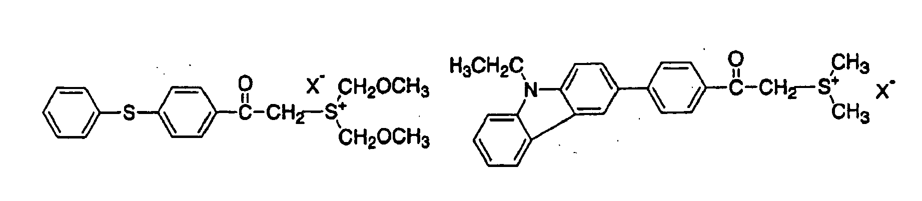

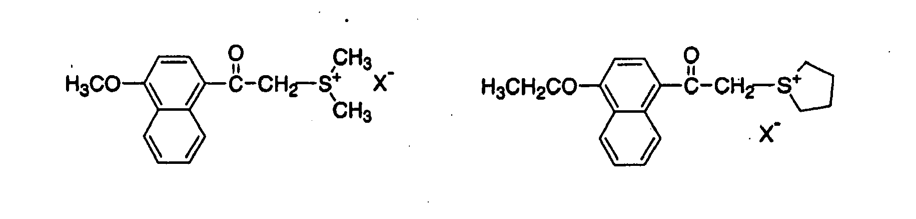

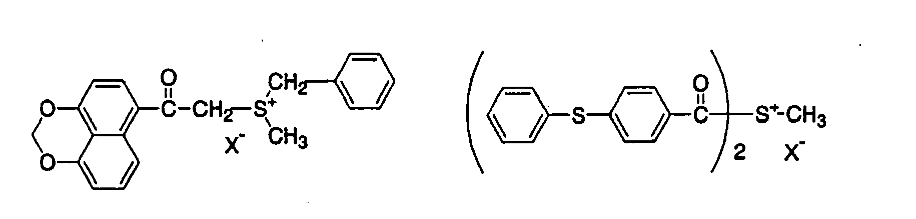

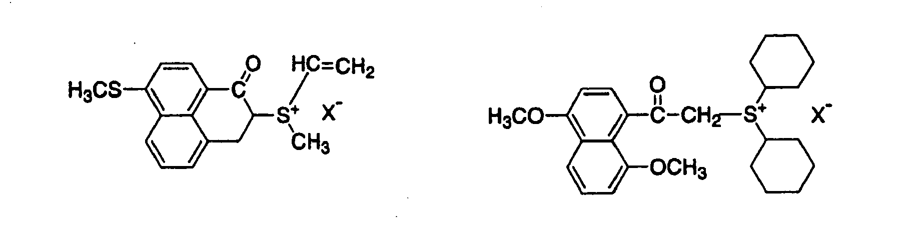

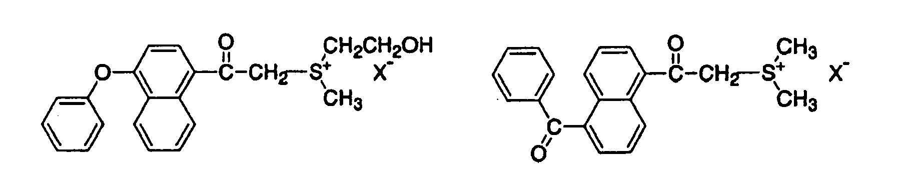

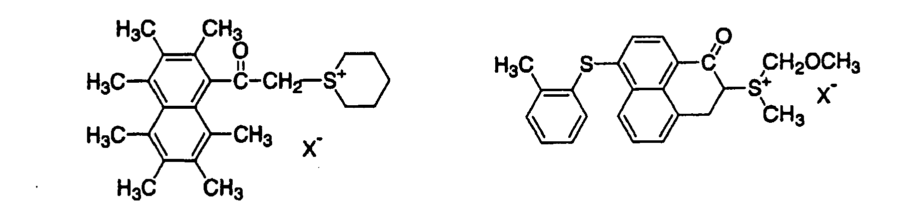

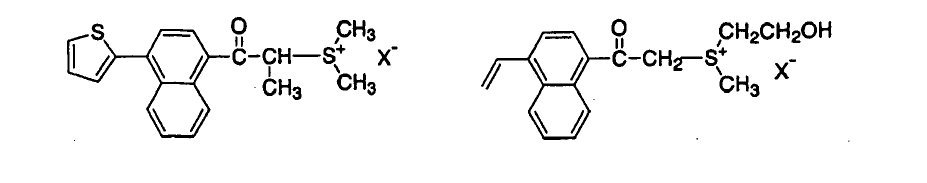

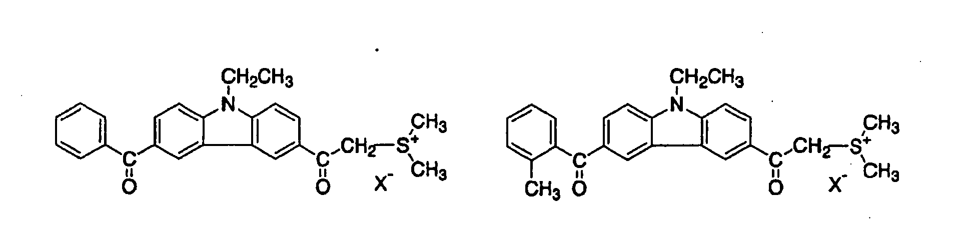

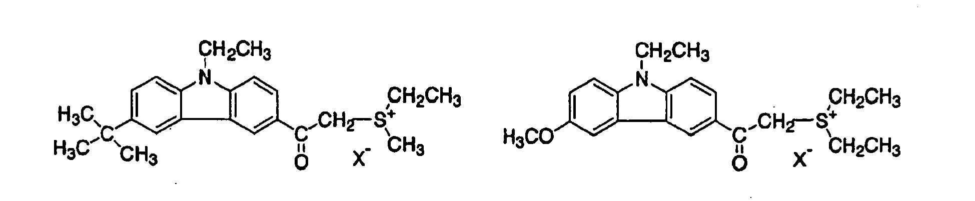

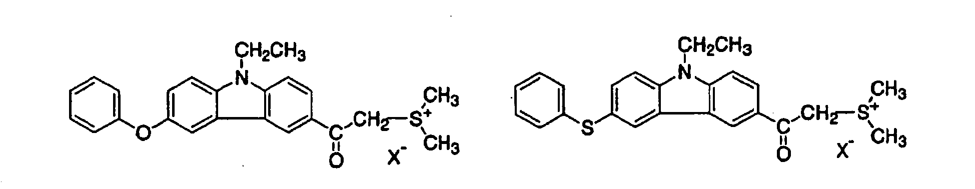

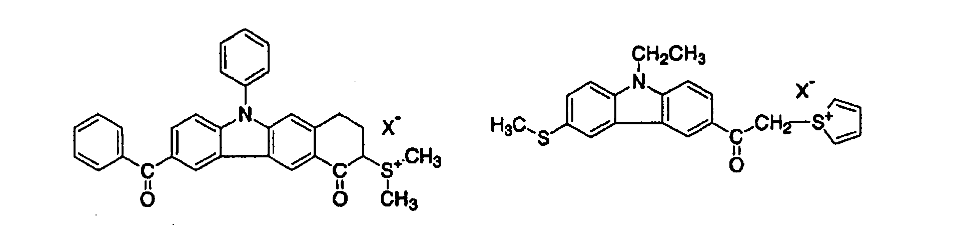

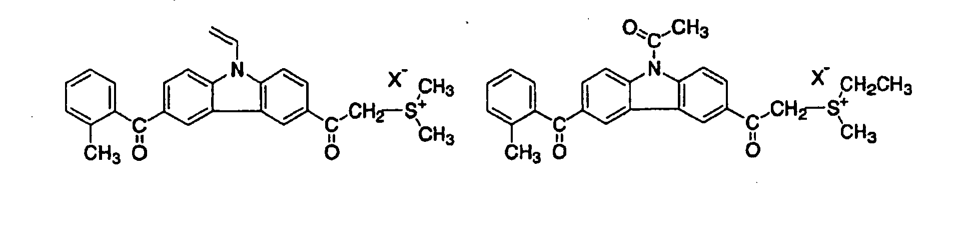

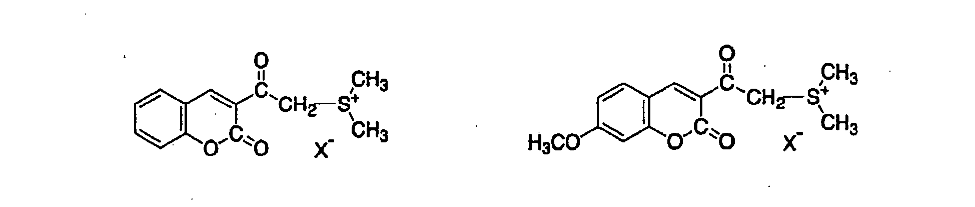

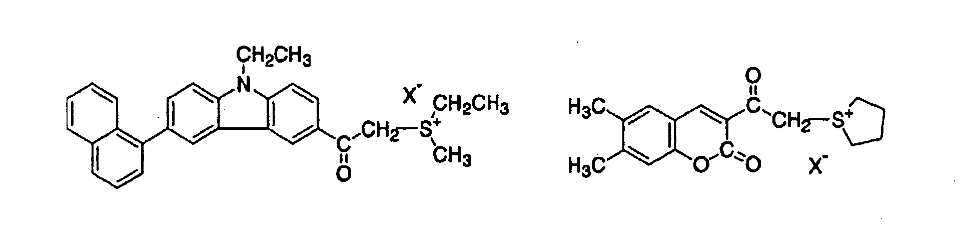

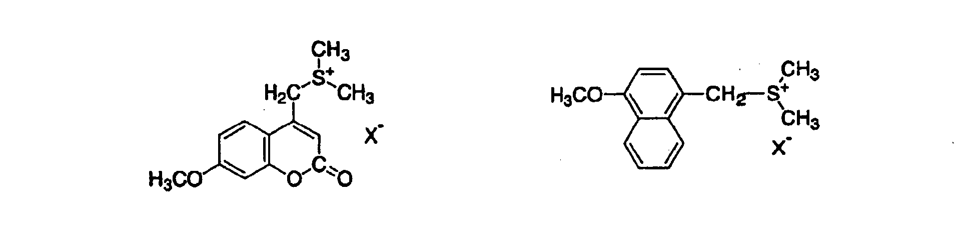

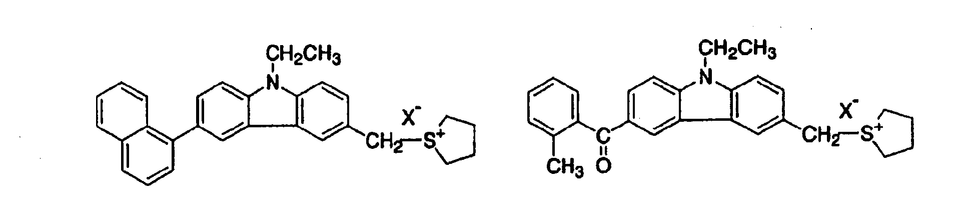

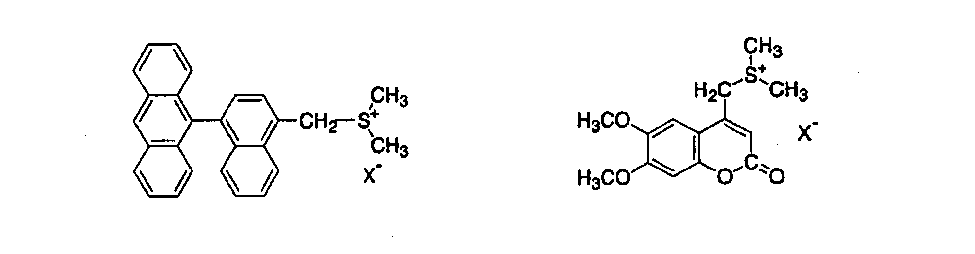

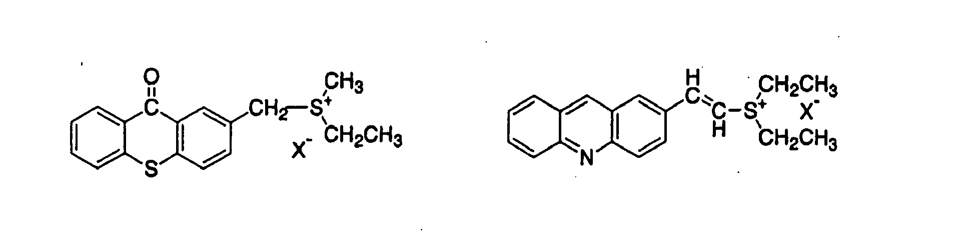

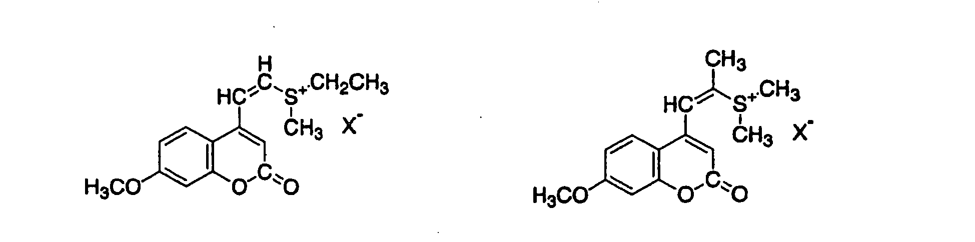

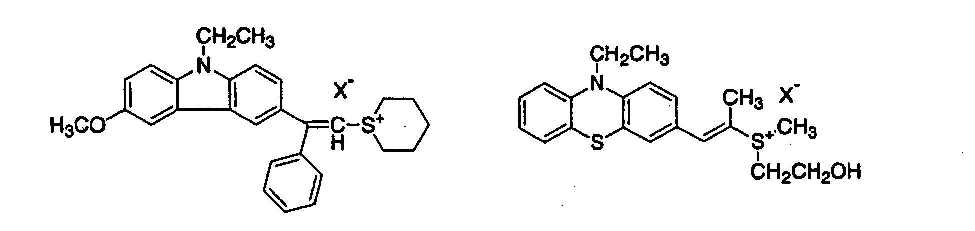

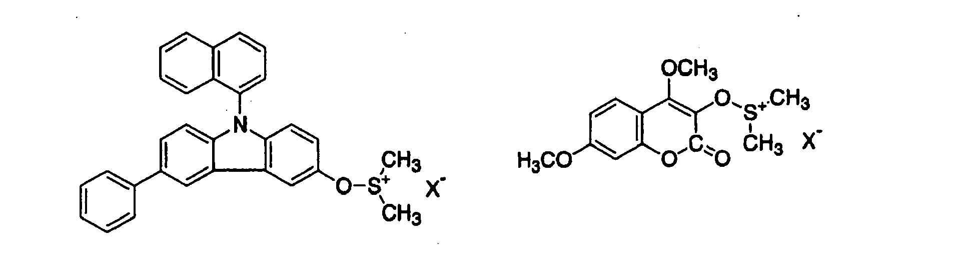

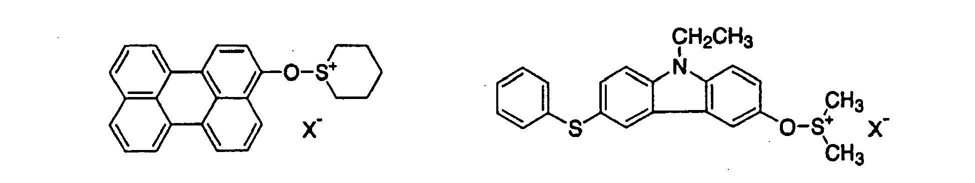

Further, the acid generator may have the following structures.

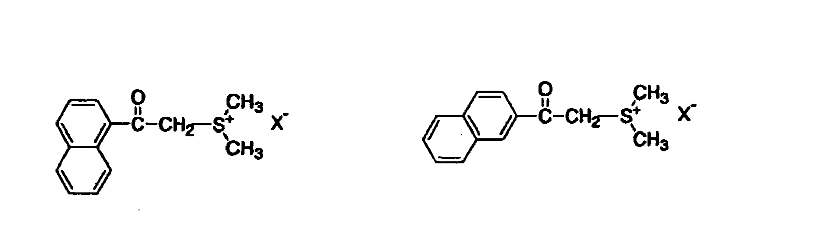

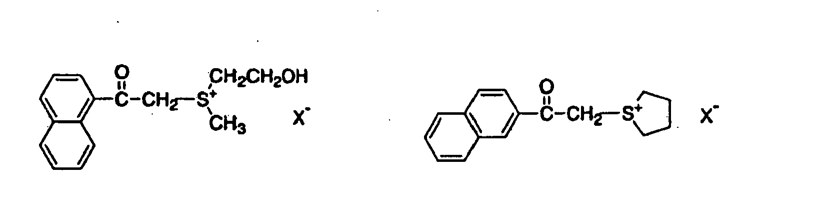

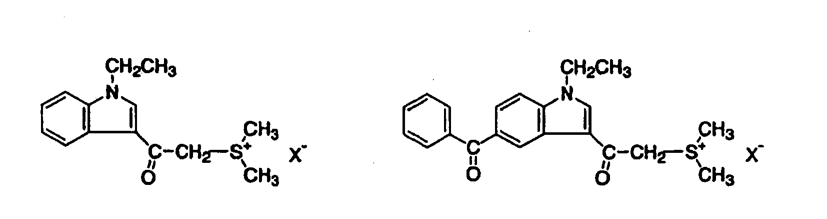

X⁻ in the above structural formulae may be any anion selected from the structures listed below.

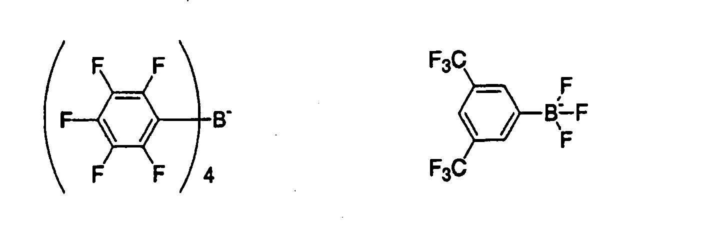

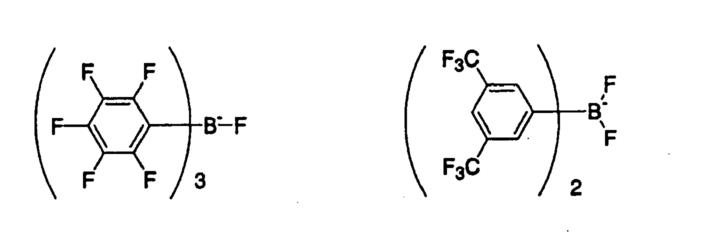

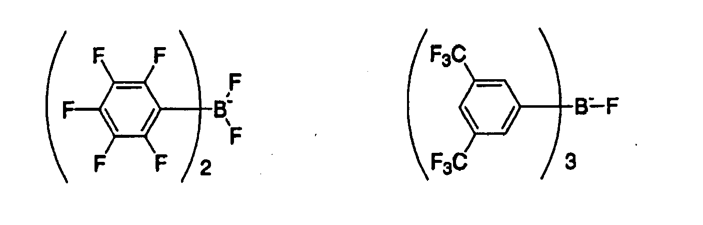

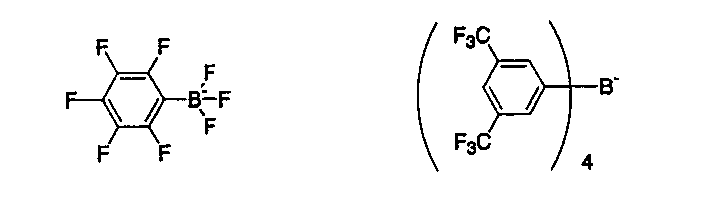

Among them, preferable is a sulfonium cation of the general formula (2) wherein R₂ and R₃ are each an alkyl group which may have a substituent from the viewpoints of availability, ease of synthesis, and solubility in the cationic polymerizable compound (B). Further preferable is an alkyl group having 1 to 6 carbon atoms wherein R₃ and R₃ may have a substituent, and further preferable is an alkyl group having 1 or 2 carbon atoms.

The acid generator (A) used in the invention is used alone or in combination of two or more of them.
Further, it may be used in combination with a thermal acid generator. In case that a semiconductor device, supporting member, and base material to be bonded have heat stability, a thermal acid generator may be concurrently used and heated after photoirradiation. This allows faster progress of crosslinking of the cationic polymerizable compound (B).

The amount of the acid generator (A) used in the invention is preferably in the range of 0.01 parts by weight to 20 parts by weight, and most preferably 0.5 parts by weight to 10 parts by weight relative to 100 parts by weight of the cationic polymerizable compound (B).
In case that the addition amount of the acid generator (A) is less than 0.01 parts by weight, polymerization or crosslinking through cationic polymerization may not sufficiently progress. In such cases, the resulting adhesive composition may not achieve favorable adhesion strength, sealing composition may not achieve a favorable sealing degree, and optical waveguide forming material may require a significantly large amount of irradiation with an active energy line for sufficient curing, or may not be sufficiently cured due to poor sensitivity thereof.
In case that the addition amount of the acid generator (A) is higher than 20 parts by weight, the resulting adhesive composition or sealing composition may not achieve sufficient cohesiveness and adhesion strength due to excessive presence of low molecular components. This may also result in fears about high amounts of residual ionic substances in the cured article, and the increase in cost. With regard to an optical waveguide forming material, its sensitivity will not be improved even if the addition amount of the acid generator (A) is more than 20 parts by weight, on the contrary higher amounts of uncured components remain in the cured article, which may deteriorate the physical properties of the cured article.

### [Cationic polymerizable compound (B)]

In the next place, the cationic polymerizable compound (B) is further described. The cationic polymerizable compound (B) is crosslinked by an acid generated from the acid generator (A) upon irradiation with active energy line. The cationic polymerizable compound (B) may be formed from various monomers, oligomers, or polymers having within the molecule thereof a cationic polymerizable functional group, for example, a vinyl ether group, epoxy group, alicyclic epoxy group, oxetanyl group, episulphide group, ethylene imine group, and hydroxy group. Further, examples of said polymers include, but not limited to, various polymers such as acrylic, urethane, polyester, polyolefin, polyether, natural rubber, block copolymer rubber, and silicone polymers. In particular, for an optical waveguide forming material, the cationic polymerizable compound (B) may be a hydrolysate of a hydrolysable silane compound.

The said cationic polymerizable compound (B) may be used alone, or in combination of two or more of them. The said cationic polymerizable compound (B) is preferably a compound having an epoxy group, oxetanyl group, or vinyl ether group, and most preferably a compound having an epoxy group or an oxetanyl group. These functional groups are polymerized with relatively high reactivity, and are cured in a short time, which allows the reduction of the curing process or sealing process.

Examples of the compound having an epoxy group include alcohol type epoxy resins such as bisphenol A type epoxy resins, glycidyl ether type epoxy resins, phenol novolac type epoxy resins, bisphenol F type epoxy resins, bisphenol S type epoxy resins, cresol novolac type epoxy resins, glycidyl amine type epoxy resins, naphthalene type epoxy resins, aliphatic epoxy resins, alicyclic epoxy resins, heterocyclic epoxy resins, multifunctional epoxy resins, biphenyl type epoxy resins, glycidyl ester type epoxy resins, and hydrogenated bisphenol A type epoxy resins; halogenated epoxy resins such as brominated epoxy resins; rubber modified epoxy resins, urethane modified epoxy resins, epoxidatied polybutadienes, epoxidated styrene-butadiene-styrene block copolymer, epoxy group-containing polyester resins, epoxy group-containing polyurethane resins, and epoxy group-containing acrylic resins. These epoxy resins may be liquid or solid at room temperature. Further, epoxy group-containing oligomers are preferably used, and examples thereof include a bisphenol A type epoxy oligomer (e.g., EPIKOTE 1001 and 1002 manufactured by Yuka-shell Epoxy Co., Ltd.). Further, addition polymers of said epoxy group-containing monomer or oligomer may be used, and examples thereof include glycidyl polyester, glycidyl polyurethane, and glycidyl acryl.

Among them, bisphenol A type epoxy resins, bisphenol F type epoxy resins, naphthalene type epoxy resins, alicyclic epoxy resins, aliphatic epoxy resins, and others are preferably used because they exhibit higher cationic photopolymerizability, and are highly efficiently cured with less amounts of light. For an optical waveguide forming material, epoxy group-containing polysilanes are also preferably used. These epoxy group-containing compounds may be used alone, or in combination of two or more of them.

For an optical waveguide forming material, in addition to the epoxy group-containing compounds exemplified above, a fluorinated epoxy resins is also exemplified. A fluorinated epoxy resin has a smaller refractive index in comparison with a hydrocarbon type epoxy compound having a similar structure, hence it is a suitable resin for adjusting the refractive index of the optical waveguide of the invention to a desired value.

Specific examples of the alicyclic epoxy resin include, but not limited to, 1,2:8,9-diepoxy limonene, 4-vinyl cyclohexene monoepoxide, vinyl cyclohexene dioxide, methylated vinylcyclohexene dioxide, (3,4-epoxycyclohexyl)methyl -3,4-epoxycyclohexyl carboxylate, bis-(3,4-epoxycyclohexyl)adipate, norbornene monoepoxide, limonene monoepoxide, 2-(3,4-epoxycyclohexyl-5,5-spiro-3,4-epoxy)cyclohexanone-meta-dioxane, bis-(3,4-epoxycyclohexylmethylene) adipate, bis-(2,3-epoxycyclopentyl) ether, (2,3-epoxy-6-methylcyclohexylmethyl) adipate, dicyclopentadiene dioxide, 2-(3,4-epoxycyclohexyl-5,5-spiro-3,4-epoxy)cyclohexane-meta-dioxane, 2,2-bis[4-(2,3-epoxypropoxy)cyclohexyl] hexafluoropropane, and BHPE-3150 (alicyclic epoxy resin manufactured by Daicel Chemical Industries, Ltd., softening point 71 °C).

Specific examples of the aliphatic epoxy resin include, but not limited to, 1,4-butane diol diglycidyl ether, 1 ,6-hexanediol diglycidyl ether, ethylene glycol diglycidyl ether, ethylene glycol monoglycidyl ether, propylene glycol diglycidyl ether, propylene glycol monoglycidyl ether, polyethylene glycol diglycidyl ether, propylene glycol diglycidyl ether, neopentyl glucol diglycidyl ether, neopentyl glucol monoglycidyl ether, glycerol diglycidyl ether, glycerol triglycidyl ether, trimethylolpropane diglycidyl ether, trimethylolpropane monoglycidyl ether, trimethylolpropane triglycidyl ether, diglycerol triglycidyl ether, sorbitol tetraglycidyl ether, allylglycidyl ether, and 2-ethylhexyl glycidyl ether.

Examples of the oxetanyl group-containing compound include, but not limited to, a phenoxymethyl oxetane, 3,3-bis(methoxymethyl)oxetane, 3,3-bis(phenoxymethyl) oxetane, 3-ethyl-3-(phenoxymethyl)oxetane, 3-ethyl -3-(2-ethyl hexyloxymethyl) oxetane, 3-ethyl-3-{[3-(triethoxysilyl)propoxy]methyl} oxetane, di[1-ethyl(3-oxetanyl)]methyl ether, oxetanyl silsesquioxane, phenol novolac oxetane, and 1,4-bis{[(3-ethyl-3-oxetanyl)methoxy]methyl} benzene.

Examples of the hydrolysable silane compound include compounds having a substituent which is hydrolyzed to generate silanol upon heating in the temperature range from 25°C to 100°C usually in the presence of no catalyst and excessive water, or a substituent capable of forming a siloxane condensate.

Hydrolysate of the hydrolysable silane compound of the invention may contain a hydrolysable silane compound which is partially unhydrolyzed, and the hydrolysate of the hydrolysable silane compound include those containing a silanol group generated by a hydrolysis reaction, and partial condensates in which some silanol groups are condensed each other.

Examples of the hydrolysable silane compound include, but not limited to, a methylalkoxysilane such as methyltrimethoxysilane, tetraalkoxysilane such as tetramethoxysilane, methyltrichlorosilane, dimethyldichlorosilane, dimethyldiacetoxysilane, dimethyldiaminosilane, and trimethylchlorosilane.

In the composition of the invention, a polyimide resin may be used for the purpose of improving heat resistance. It is particularly preferably used for an optical waveguide forming material.

The composition of the invention must exhibit adhesiveness before irradiation with an active energy line, and no adhesiveness after being cured by irradiation with an active energy line. In case that sufficient adhesiveness is not achieved with the composition of the acid generator (A) and the cationic polymerizable compound (B), an adhesive polymer may be added.

Said adhesive polymer is not particularly limited as long as it offers adhesiveness and cohesiveness at room temperature, and examples thereof include acrylic polymers, polyesters, polyurethanes, silicones, polyethers, polycarbonates, polyvinyl ethers, polyvinyl chlorides, polyvinyl acetates, polyisobutylenes, organic polyvalent isocyanatos, and organic polyvalent imines. Further, said adhesive polymer may be a copolymer containing monomers as the main ingredient of said polymer. In particular, acrylic polymers or polyesters are preferable because they have been commonly used as main ingredients of adhesives due to their excellent initial adhesiveness, and readily controllable as to their adhesive properties.

The adhesive polymer is preferably 0 to 2000 parts by mass relative to 100 parts by mass of the whole amount of the composition.

As a coupling agent for the composition of the invention, a silane coupling agent or titanate coupling agent may be used. The use of these agents allows the improvement of adhesiveness between the cured article of the composition of the invention and a semiconductor device, supporting member, or base material.

Examples of the silane coupling agent include, but not limited to, epoxy silane such as γ-glycidoxypropyltrimethoxysilane, γ-glycidoxypropyltriethoxysilane, and β-(3,4-epoxycydohexyl)ethyltrimethoxysilane, amino silane such as γ-aminopropyltriethoxysilane, N-β (aminoethyl)γ-aminopropyltrimethoxysilane, N-β (aminoethyl)γ-aminopropylmethyldimethoxysilane, γ-aminopropyltrimethoxysilane, and γ-ureidopropyltriethoxysilane, mercapto silane such as 3-mercaptopropyltrimethoxysilane, vinyl silane such as p-styryltrimethoxysilane, vinyltrichlorosilane, vinyltris(β-methoxyethoxy)silane, vinyltrimethoxysilane, vinyltriethoxysilane, and γ-methacryloxypropyltrimethoxysilane, and epoxy, amino, and vinyl polymer silans. In particular, epoxy silane, amino silane, and mercapto silane are preferable.

On the other hand, examples of the titanate coupling agent include, but not limited to, isopropyltriisostearoyl titanate, isopropyltri(N-aminoethyl-aminoethyl) titanate, diisopropylbis(dioctylphosphate) titanate, tetraisopropyl bis(dioctylphosphite) titanate, tetraoctylbis(ditridecylphosphite) titanate, tetra(2,2-dialtyloxymethyl-1-butyl)bis(ditridecyl)phosphite titanate, bis(dioctylpyrophosphate)oxy acetate titanate, and bis(dioctylpyrophosphate)ethylene titanate.

These coupling agents may be used alone or in combination of two or more of them. The content of the coupling agent is preferably in the range of 0.1 to 1 part by weight relative to the whole amount of the cationic polymerizable compound (B).

Further, the use of the acid generator (A) allows very rapid and reliable curing of the composition of the invention by irradiation with an energy line, particularly light in the wavelength region from 350 nm to 450 nm, even with no use of sensitizer. However, if necessary, a sensitizer may be used.

Examples of the sensitizer which may be used in combination with the invention include condensed polycyclic aromatic derivatives such as naphthalene derivatives, anthracene derivatives, phenanthrene derivatives, pyrene derivatives, naphthacene derivatives, perylene derivatives, and pentacene derivatives, acridine derivatives, benzothiazole derivatives, unsaturated ketones represented by chalcone derivatives and dibenzalacetone, 1,2-diketone derivatives represented by benzil and camphorquinone, benzoin derivatives, fluorene derivatives, naphthoquinone derivatives, anthraquinone derivatives, xanthene derivatives, thioxanthene derivatives, xanthone derivatives, thioxanthone derivatives, coumarin derivatives, ketocoumarin derivatives, polymethine dyes such as cyanine derivatives, melocyanine derivatives and oxonol derivatives, acridine derivatives, azine derivatives, thiazine derivatives, phenothiazine derivatives, oxazine derivatives, indoline derivatives, azulene derivatives, azulenium derivatives, squarylium derivatives, porphyrin derivatives, tetraphenyl porphyrin derivatives, triarylmethane derivatives, tetrabenzoporphyrin derivatives, tertapyrazinoporphyrazine derivatives, phthalocyanine derivatives, tetraazaporphyrazine derivatives, tetraquinoxalyloporphyrazine derivatives, naphthalocyanine derivatives, subphthalocyanine derivatives, pyrylium derivatives, thiopyrylium derivatives, tetraphyrin derivatives, anulene derivatives, spiropyran derivatives, spirooxazine derivatives, thiospiropyran derivatives, carbazole derivatives, metal allene complexes, and organic ruthenium complexes. In addition, more specific examples thereof include, but not limited to, dyes and sensitizers described in "Shikiso Handbook (Handbook of Dyes)", edited by Shin Ohkawara et al. (1986, Kodansha Ltd. Publishers), "Kinohseishikiso no Kagaku (Chemistry of Functional Dyes)", edited by Shin Ohkawara et al. (1981, CMC Inc.), "Tokyshu Kinohzairyo (Special Functional Materials)", edited by Chuhzaburo Ikemori et al. (1986, CMC Inc.), and "Kankozairyo List Book (List of Photosensitive Materials)", edited by the Technical Association of Photosensitive Polymers of Japan (1996, Bunshin Shuppan Co., Ltd.). These may be used in combination of two or more of them in an optional ratio.

Of these sensitizers, preferable examples are condensed polycyclic aromatic derivatives of naphthalene derivatives and anthracene derivatives, and phenothiazine derivatives, carbazole derivatives, and benzothiazole derivatives. Of these, particularly preferable examples are anthracene derivatives.

Specific examples of the anthracene derivatives include anthracene, 1-anthracenecarboxylic acid, 2-anthracenecarboxylic acid, 9-anthracenecarboxylic acid, 9-anthraaldehyde, 9,10-bis(chloromethyl)anthracene, 9,10-bis(phenylethynyl)anthracene, 9-bromoanthracene, 1-chloro-9,10-bis(phenylethynyl)anthracene, 9-cyanoanthracene, 9,10-dibromoanthracene, 9,10-dicyanoanthracene, 9,10-dimethylanthracene, 9,10-dibutylanthracene, 9,10-diphenylanthracene, 9,10-di-p-tolylanthracene, 9,10-bis(p-methoxyphenyl)anthracene, 2-hydroxymethylanthracene, 9-hydroxymethylanthracene, 9-methylanthracene, 9-phenylanthracene, 9,10-dimethoxyanthracene, 9,10-diethoxyanthracene, 9,10-dibutoxyanthracene, 9,10-diphenoxyanthracene, 9,10-dimethoxyanthracene-2-sodium sulfonate, 1,4,9,10-tetrahydroxyanthracene, 2,2,2-trifluoro-1-(9-anthryl)ethanol, 1,8,9-trihydroxyanthracene; 1,8-dimethoxy-9,10-bis(phenylethynyl)anthracene, 9-vinylanthracene, 9-anthracene methanol, and trimethylsiloxy ether of 9-anthracene methanol. In addition, other examples of the sensitizer include phenothiazine, N-ethyl carbazole, N-phenyl carbazole, 1-methoxy naphthalene, 2-methoxy naphthalene, and 1,4-dimethoxy naphthalene.

The addition amount of said sensitizer is not particularly limited, but preferably 0 to 100 parts by weight relative to 100 parts by weight of the acid generator of the invention.

Although the acid generator (A) used in the invention has sufficiently high sensitivity as an acid generator, it may be used in combination with another acid generator. Acid generators which may used in combination with the acid generator (A) are not particularly limited, and may be selected appropriately from materials known in the art. Examples of the known materials include "PAG", "acid generator", "photoacid generator", "photopolymerization initiator", "cationic polymerization initiator", and "polymerization catalyst". In case that above acid generators are used, these may be used alone or in combination of a plurality of them.

Examples of another acid generators which may be used in combination with the acid generator (A) used in the invention include, in the first place, onium salt-based compounds. Examples of the onium salt-based compounds include sulfonium salt-based, iodonium salt-based, phosphonium salt-based, diazonium salt-based, pyridinium salt-based, benzothiazolium salt-based, sulfoxonium salt-based, and ferrocene-based compounds. These are not particularly limited as to their structure, and may have a polyvalent cationic structure such as dication. Counter anions of them selected appropriately from known ones may be also used.

Further, examples of energy line-sensitive acid generators other than onium salts which may be used in combination with the acid generator used in the invention include, but not limited to, nitrobenzyl sulfonates, alkyl or aryl -N-sulfonyloxy imides, alkylsulfonic acid esters which may be halogenated, 1,2-disulfones, oxime sulfonates, benzointosylates, β-ketosulfones, β-sulfonyl sulfones, bis(alkylsulfonyl) diazomethanes, imino sulfonates, imide sulfonates, and compounds having a trihaloalkyl group such as trihalomethyl triazines.

The ratio of the acid generator used in combination with the acid generator (A) used in the invention is not particularly limited, but preferably in the range from 0 to 99 parts by weight relative to 100 parts by weight of the acid generator (A) of the invention.

To the composition of the invention, a filler may be added for the purpose of improving properties such as heat resistance, adhesiveness, and hardness. The filler is preferably an inorganic filler. Specific examples of the filler include fused silica powder, crystal silica powder, powder or spherical beads of alumina, zircon, calcium silicate, calcium carbonate, silicon carbide, aluminum nitride, boron nitride, beryllium, zirconia, talc, clay, and aluminum hydroxide, monocrystal fibers of potassium titanate, silicon carbide, silicon nitride, and alumina, and glass fibers. One or more of them may be added. Among these fillers, fused silica is preferable from the viewpoint of reducing coefficient of linear expansion, or alumina from the viewpoint of high heat conductivity. The content thereof is preferably 0 to 2000 parts by mass relatives to 100 parts by mass of the whole amount of an adhesive composition or sealing composition. Further, the filler is preferably thoroughly mixed in advance.

As necessary, a tackifier for further improving adhesiveness, a viscosity adjusting agent for adjusting viscosity, thixotropic agent for imparting thixotropy, physical property adjusting agent for improving tensile properties and other properties, heat stabilizer, flame retardant, anti-static agent, "compound having a radical polymerizable unsaturated group and photoradical initiator" for improving curability by light (active energy line), and the like may also be used.

Examples of said flame retardant include known ones such as inorganic flame retardants such as antimony trioxide, antimony pentoxide, tin oxide, tin hydroxide, molybdenum oxide, zinc borate, barium metaborate, red phosphorus, aluminum hydroxide, magnesium hydroxide, and calcium aluminate, bromine-based flame retardants such as tetrabromophthalic anhydride, hexabromobenzene, and decabromobiphenyl ether, and phosphoric acid-based flame retardants such as tris(tribromophenyl) phosphate. The content thereof is preferably 0 to 100 parts by weight relatives to 100 parts by weight of the whole amount of an adhesive composition.

The composition of the invention may be dissolved in a solvent in which above components are soluble, and applied on a base material. The solvent used here is not particularly limited as long as in which the composition of the invention is uniformly soluble. Specific examples of preferable solvents include 1,1,2,2-tetrachloroethane, ethylene dichloride, cyclohexanone, cyclopentanone, γ-butyrolactone, methyl ethyl ketone, ethylene glycol monomethyl ether, ethylene glycol monoethyl ether, methyl methoxy propionate, ethyl ethoxy propionate, methyl pyruvate, ethyl pyruvate, propyl pyruvate, ethylene glycol monoethyl ether acetate, propylene glycol monomethyl ether, propylene glycol monomethyl ether acetate, toluene, ethyl acetate, isoamyl acetate, methyl lactate, ethyl lactate, ethyl ethoxy propionate, N,N-dimethylformamide, N,N-dimethylacetamide, dimethylsulfoxide, and N-methylpyrrolidone. These solvents are used alone or in combination thereof.

An energy line is used for generating an acid from the acid generator (A) in the composition of the invention to polymerize or crosslink the cationic polymerizable compound (B). The energy line is not particularly limited as long as it is absorbed and decomposed by the acid generator (A) for acid generation, and will not damage adherends. Examples of such energy lines are the same as the energy lines described for the photoacid generator (A). Further, as necessary, another curing means such as thermal curing may be concurrently used within a range which will not deteriorate a semiconductor device, supporting member, and base material. The heating temperature in the presence of said thermal curing is not particularly limited, but preferably 50 to 200°C for an adhesive composition, 50 to 100°C for a sealing composition, and 50 to 300°C for an optical waveguide forming material.

### [Process for producing bonded article]

Formation of an adhesive layer with the adhesive composition of the invention may be achieved by applying the adhesive composition to the surface to be coated to form an adhesive layer, or by applying the composition to a base material to form an adhesive film, and then laminating the adhesive film onto the surface to be coated, followed by removal of the base material to form an adhesive layer. The use of the adhesive composition of the invention as an adhesive film allows simplification of the process of applying an adhesive to a semiconductor device with no squeezing out of the adhesive from the semiconductor device.

The base material used for applying the adhesive composition of the invention is not particularly limited, and may be any known materials. Examples thereof include transparent films such as a polyethylene film, polypropylene film, polybutene film, polybutadiene film, polymethyl pentene film, polyvinyl chloride film, vinyl chloride copolymer film, polyethylene terephthalate film, polyethylene naphthalate film, polybutylene terephthalate film, polyurethane film, ethylene vinyl acetate film, ionomer resin film, ethylene. (meth) acrylic acid copolymerization film, ethylene .(meth)acrylic ester copolymerization film, polystyrene film, polycarbonate film, cellophane, and polyimide. Crosslinking films thereof are also useful. Further, laminated films thereof are also useful. In addition, colored opaque films thereof and fluorocarbon resin films are also useful.

Any known processes may be used for applying the adhesive composition of the invention to a base material or a surface to be coated. Examples thereof include coating by a bar coater, applicator, calender process, extrusion coating, comma coater, die coater, or lip coater, and application methods such as a dispense method, stamping method, and screen printing method. Further, the adhesive composition of the invention may contain a solvent. In such cases, the solvent may be removed after the application through an appropriate dry process to form a film.

The thickness of the adhesive layer of the invention may be appropriately selected according to the specifications of the semiconductor device, and not particularly limited, but usually in the range of 1 to 1000 µm, preferably 3 to 100 µm, and further preferably 10 µm to 75 µm. If the adhesive layer has a thickness less than 1 µm, adhesiveness of the adhesive may be affected by irregularity on the surface of a semiconductor device or supporting member. On the other hand, if the adhesive layer has a thickness exceeding 1000 µm, curing time may be excessively prolonged.

The adhesive composition of the invention is suitably used as an adhesive for bonding a semiconductor device to a supporting member.

The semiconductor device of the invention is not particularly limited, and examples thereof include a known semiconductor material such as silicon having formed thereon an integrated circuit.

The supporting member of the invention is not particularly limited, and examples thereof include circuit board materials such as a lead frame, polyimide substrate, and epoxy substrate, and insulating layers comprising a polyphenylene ether resin, polyolefin resin, fluorocarbon resin, thermoplastic elastomer, epoxy resin, or polyimide resin. Further, in case that semiconductor devices are laminated, said semiconductor device also serves as a supporting member.

In case that a semiconductor device is bonded to a supporting member, as a most common bonding method with the adhesive composition of the invention, in the first place, the adhesive composition of the invention is applied to the surface of the semiconductor device to be bonded to the supporting member for forming an adhesive layer. Thereafter, the semiconductor device is placed on the supporting member, followed by irradiation with light containing at least a portion of rays from 350 nm to 450 nm to bond the semiconductor device to the supporting member. Further, as necessary, the semiconductor device and the supporting member may be heated within a range which will not deteriorate them.

In another process, in the first place, the adhesive composition of the invention is applied to the surface of the semiconductor device to be bonded to the supporting member for forming an adhesive layer. Thereafter, irradiation with light containing at least a portion of rays from 350 nm to 450 nm is performed, then the semiconductor device is placed on the supporting member to bond the semiconductor device to the supporting member. Further, as necessary, the semiconductor device and the supporting member may be heated or irradiated with light again within a range which will not deteriorate them.

In such cases, the semiconductor device may be bonded to the supporting member with the adhesive film of the invention in place of direct application of the adhesive composition. Further, the surface to be coated with the adhesive composition of the invention or to be bonded to an adhesive film may be a supporting member surface to be bonded to a semiconductor device. In case that a semiconductor device is bonded to a supporting member after photoirradiation, the photoirradiation may be before or after removal of the base material.

During said adhesion process, in case that adherends pass through light containing at least a portion of rays from 350 nm to 450 nm, they may be irradiated with light from any direction. In case that the adherends do not pass through light containing at least a portion of rays from 350 nm to 450 nm light, the adhesive composition or adhesive film may be irradiated with light through a gap between the adherends. Alternatively, the adhesive composition applied or adhesive film affixed to a semiconductor device or supporting member may be irradiated with light, followed by bonding to a supporting member or semiconductor device.
According to the above processes, a bonded article bonding a semiconductor device to a supporting member is obtained.

Further, the adhesive film of the invention has initial adhesiveness, it thus serves as a dicing tape by affixing it to the surface of a semiconductor device to be bonded to a supporting member before dicing.

### [Sealing process]

The sealing composition of the invention is used as a sealant for protecting a base material from the external environment basically by curing on the base material. The subject to be coated or filled with the sealing composition of the invention is not particularly limited, and the composition may be applied to any objects such as planar, three-dimensional, or uneven ones.

The base material used for applying or filling the sealing composition of the invention is not particularly limited, and may be any known materials. Examples thereof include synthetic resin films represented by a PET film, polypropylene film, cellophane, and polyimide, various papers, cloth, nonwoven fabric, metal foils represented by aluminum foil, a resin plate such as a acryl plate, metal plate, lumber, foam, glass, and a circuit board material such as glass epoxy substrate.

Further, the base material of the invention includes optic devices such as a light source, detection and passive devices, and semiconductor devices of a light emitting diode device, transistor, integrated circuit, large scale integrated circuit and thyristor. Further, the base material of the invention also includes a device and circuit mounted or formed on above-described base materials, such as an organic EL device substrate.

For sealing a semiconductor device or the like, a low-pressure transfer system is the most common sealing process using the sealing composition of the invention. Also useful for sealing are injection molding, compression molding, and cast molding. The semiconductor device is sealed with the sealing composition, irradiated with an active energy line for curing to seal the semiconductor device.

More specifically, a semiconductor device is dipped in the sealing composition of the invention placed in a mold, and irradiated with an active energy line in that state for curing the composition, followed by removal of the mold. The mold comprises a material which readily passes an active energy line, for example, glass, ceramic, plastic, and silicone rubber.

A liquid crystal panel or an organic EL panel is sealed basically by bonding two base materials together. The sequence of the contact of the sealing composition of the invention to the two base materials is not particularly limited. In case that the composition is applied to a base material, the composition may be applied to a release-coated base material, transferred to another base material using a roll or laminator, followed by removal of the release-coated base material to form an adhesive sheet which is substantially composed of a single layer of the sealing composition of the invention.

The process for sealing a liquid crystal panel is described below in detail. In the first place, the sealing composition of the invention is applied using a dispenser or the like to the rim of a surface of a glass substrate but is not applied to one opening of the glass substrate. In the next place, the treated glass substrate is superposed on a glass substrate of the same size such that the sealant layer is placed between the glass substrates. Further, an active energy line is radiated for curing, a liquid crystal is injected through the opening, and the opening is sealed.

### [Process for forming optical waveguide]

The process for forming an optical waveguide using the optical waveguide forming material of the invention is described below. The process for forming an optical waveguide using the optical waveguide forming material of the invention mainly comprises a step of forming a lower clad layer, a step of forming a core, and a step of forming an upper clad layer. The optical waveguide forming material of the invention may be used as a material for forming a lower clad layer, core, or upper clad layer.

Figs. 1 (a) through (f) show a flow sheet illustrating one embodiment of the process of the invention for forming an optical waveguide by a direct exposure method.

In the first place, a substrate 1 is prepared (Fig. 1 (a)). The substrate 1 is not particularly limited as long as it has a smooth surface, and examples thereof include a silicon substrate and glass substrate.

A lower clad layer forming material is applied to the surface of the substrate 1, and dried or prebaked to form a thin film for lower layer. Subsequently, the thin film for lower layer is irradiated with an energy-sensitive line for curing to form a lower clad layer 2 (Fig. 1 (b)). In the step of forming the lower clad layer 2, it is preferable that the thin film is irradiated all over with an energy-sensitive line for curing the whole.

The means for applying the lower clad layer forming material may be a spin coat method, dipping method, spray method, bar coat method, roll coat method, curtain coat method, gravure printing method, silk screen method, or ink jet method, or the like method. Among them, a spin coat method is particularly preferable because it provides a coated film having a uniform thickness.

In these cases, the lower clad layer forming material is preferably used after diluted with an organic solvent.

The organic solvent is not particularly limited as long as in which the lower clad layer forming material is uniformly soluble. Specific examples of preferable organic solvents include 1,1,2,2-tetrachloroethane, ethylene dichloride, cyclohexanone, cyclopentanone, γ-butyrolactone, methyl ethyl ketone, ethylene glycol monomethyl ether, ethylene glycol monoethyl ether, methyl methoxy propionate, ethyl ethoxy propionate, methyl pyruvate, ethyl pyruvate, propyl pyruvate, ethylene glycol monoethyl ether acetate, propylene glycol monomethyl ether, propylene glycol monomethyl ether acetate, toluene, ethyl acetate, isoamyl acetate, methyl lactate, ethyl lactate, ethyl ethoxypropionate, N,N-dimethylformamide, N,N-dimethylacetamide, dimethyl sulfoxide, and N-methyl pyrrolidone. These solvents are used alone or in mixture.

Further, a coated film formed from the lower clad layer forming material may be dried at a temperature from 50 to 90°C to make a thin film. Alternatively, if necessary, it may be prebaked by heating at a temperature from 60 to 200°C for making a thin film. The prebaking conditions vary depending on the type of components of the lower clad layer forming material, and the mixing ratio. In usual cases, prebaking is preferably performed at a temperature from 60 to 120°C for 10 to 600 seconds. The description about the application method in the process of forming a lower clad layer is applicable to the below-described processes of forming a core and an upper clad layer.

Further, the energy line for forming the lower clad layer is not particularly limited as long as it is absorbed and decomposed by the acid generator (A) for acid generation, and will not damage adherends. Examples of such energy lines are the same as the energy lines described for the photoacid generator (A).

Further, after irradiation with an active energy, heat treatment may be performed for thoroughly curing all over the coated film, if necessary. The heating conditions vary depending on the formulation of the lower clad layer forming material, and the type of additives. In usual cases, heating is performed at a temperature of 30 to 400°C, preferably 50 to 300°C for, for example, 5 minutes to 72 hours. The descriptions about the energy line and heating treatment in the process of forming a lower clad layer are applicable to the below-described processes of forming a core and an upper clad layer.

In the next place, a core forming material is applied to the lower clad layer 2, and dried or further prebaked to form a core-forming thin film 3. Subsequently, the upper surface of the core-forming thin film 3 is irradiated with an active energy line 5 according to a predetermined pattern, for example through a photomask 4 having a predetermined line pattern (Fig. 1 (c)). As a result of this, irradiated areas are cured. Subsequently, the remaining uncured areas are removed by developing for forming a core 6 composed of a patterned cured film on the lower clad layer 2. (Fig. 1 (d))

Patternwise exposure is performed as described above according to a predetermined pattern, and the selectively cured thin film is subjected to development treatment by using a difference in solubility between the cured and uncured areas. Accordingly, the core 6 is formed by removing the uncured areas and leaving the cured areas after patternwise exposure (Fig. 1 (e)).

The developing solution may be an organic solvent, or an aqueous alkali solution of alkalis such as sodium hydroxide, potassium hydroxide, sodium carbonate, sodium silicate, sodium metasilicate, ammonia, ethylamine, n-propylamine, diethylamine, di-n-propyl amine, triethylamine, methyldiethylamine, N-methylpyrrolidone, dimethylethanolamine, triethanolamine, tetramethyl ammonium hydroxide, tetraethyl ammonium hydroxide, choline, pyrrole, piperidine, 1,8-diazabicyclo[5.4.0]-7-undecene, and 1,5-diazabicyclo[4.3.0]-5-nonane. Further, in case that an aqueous alkaline solution is used, the concentration in common cases is preferably within a range from 0.05 to 25% by weight, and preferably 0.1 to 3.0% by weight. It is also preferable to add an appropriate amount of a water-soluble organic solvent such as methanol and ethanol, or a surfactant to the alkali aqueous solution for using as a developing solution.

Further, the development method may be a known method such as a puddle method, dipping method, and shower development method.

In the next place, an upper clad layer forming material is applied to the surface of the lower clad layer 2 having thereon a core 6, and dried or prebaked to form an upper clad layer-forming thin film. The upper clad layer-forming thin film is irradiated with an active energy line for curing to form an upper clad layer 7 as shown in Fig. 1 (Fig. 1 (f)).

Further, the upper clad layer 7 obtained by the irradiation with an active energy line is, if necessary, preferably further postbaked as described above. Through the postbaking treatment, an upper clad layer having excellent hardness and heat resistance is obtained.

Figs. 1 (g) through (k) show a flow sheet representing another embodiment of the process of the invention for forming an optical waveguide by a photo-bleaching method. The same members as those shown in Figs. 1 (a) through (f) are indicated the same characters.

In the first place, a substrate 1 is prepared (Fig. 1 (g)).

A lower clad layer 2 is formed on the substrate 1 by the above-described method (Fig. 1 (h)).

A core-forming material is applied to the lower clad layer 2, and dried or further prebaked to form a core-forming thin film 3. Subsequently, the upper surface of the core-forming thin film 3 is irradiated with an active energy line 5 according to a predetermined pattern, for example through a photomask 4 having a predetermined line pattern (Fig. 1 (i)).

In case that the optical waveguide forming material of the invention which increases the refractive index upon irradiation with an active energy line is used as the core portion forming material, the core-forming areas are irradiated with an active energy line as shown in Fig. 1 (i).

On the other hand, in case that the optical waveguide forming material of the invention which decreases in the refractive index upon irradiation with an active energy line is used as the core portion forming material, contrary to Fig. 1 (i), a photomask is used such that the side clad layer other than the core is exclusively irradiated with an active energy.

In the next place, an upper clad layer forming material is applied to the surface of the lower clad layer 2 having formed thereon a core 6 (Fig. 1 (j)), and dried or prebaked to form an upper clad layer-forming thin film. The upper clad layer-forming thin film is irradiated with an active energy line for curing to form an upper clad layer 7 as shown in Fig. 1 (Fig. 1 (k)).

### Examples

The invention is further illustrated by following Examples, but the invention shall not be limited to the following Examples.

### [Adhesive composition]

The structures of the acid generators used in Examples and Comparatives Examples of the invention are shown below. The molar extinction coefficient was calculated from the measurement for the acid generators dissolved in acetonitrile at 25°C.

**Table 1**

| | Structure | E at 350nm |
|---|---|---|
| Compound(1) | 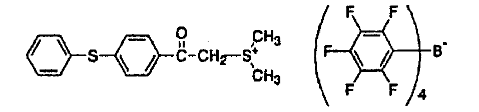 | 3700 |
| Compound(2) | 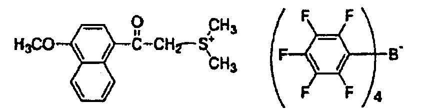 | 11800 |
| Compound(3) | 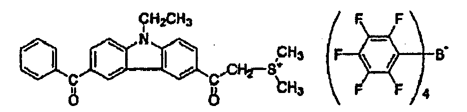 | 23200 |
| Compound (4) | 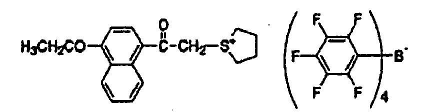 | 12000 |
| Compound(5) | 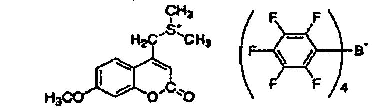 | 8490 |
| Compound(6) | 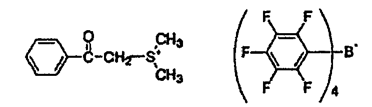 | 0 |
| Compound(7) | 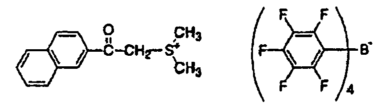 | 2500 |
| Compound(8) | 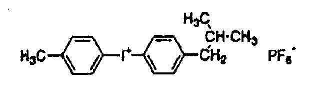 | 0 |
| Compound(9) | 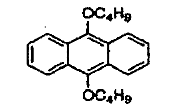 | - |

### (Example I-1)

2 parts by weight of a compound (1) as the acid generator (A) and 100 parts by weight of a bisphenol A type epoxy resin (trade name "EPIKOTE 828", manufactured by Japan Epoxy Resins Co., Ltd.) as the cationic polymerizable compound (B) were mixed to prepare an adhesive composition. 0.5 g of the adhesive composition was applied to a copper lead frame at a uniform film thickness, and irradiated with an ultraviolet ray having a wavelength of 365 nm at a dose of 3000 mJ/cm² using an extra-high pressure mercury lamp. Subsequently a silicon chip was affixed to the surface coated with said adhesive composition, thus a bonded article was obtained. The obtained bonded article was evaluated for the following items. The results are shown in Table 2.

Examples and Comparatives Examples were evaluated by the following evaluation methods.

### (1) Initial adhesion strength

The untreated bonded articles obtained in Examples or Comparatives Examples were measured for the shear strength between the silicon chip and copper lead frame.
G: Shear strength was 1 MPa or more.
F: Shear strength was 0.5 Mpa or more and less than 1 MPa.
N: Shear strength was less than 0.5 Mpa.

### (2) Adhesiveness after high-temperature treatment

The bonded articles obtained in Examples or Comparatives Examples were treated in an IR reflow furnace at a temperature of 240°C, subsequenty measured for the shear strength between the silicon chip and copper lead frame.
G: 1 MPa or more of shear strength.
F: 0.5 Mpa or more and less than 1 MPa of shear strength.
N: Less than 0.5 Mpa of shear strength.

### (Examples I-2 to I-5 and Comparative Examples I-1 to I-6)

Adhesive compositions were prepared and bonded articles comprising a silicon chip and a copper lead frame were obtained in the same manner as Example I-1 except that 2 parts by weight of the acid generator (A) in Example I-1 were replaced with 2 parts by weight each of the acid generators listed in Table 1, and the sensitizer was replaced with a specified amount of the compound listed in Table 2. The results of the evaluation on the obtained bonded articles for their initial adhesiveness and adhesiveness after high-temperature treatment are shown in Table 2.

### (Comparatives Example I-7)

An adhesive composition was prepared and a bonded article comprising a silicon chip and a copper lead frame was obtained in the same manner as Example I-1 except that 2 parts by weight of the acid generator (A) in Example I-1 were replaced with 2 parts by weight of aromatic sulfonium hexafluoro antimonate (ADEKA OPTMER SP170, manufactured by Asahi Denka Company Limited). The results of the evaluation on the obtained bonded article for its initial adhesiveness and adhesiveness after high-temperature treatment are shown in Table 2.

**Table 2 Results of evaluation on adhesive compositions**

| | | Sensitizer | | | |
|---|---|---|---|---|---|
| | Acid generator (A) | Compound | Addition amount | Initial adhesiveness | Adhesiveness after high-temperat ure treatment |
| Example I-1 | Compound (1) | - | 0 part by weight | G | G |
| Example I-2 | Compound (2) | - | 0 part by weight | G | G |
| Example I-3 | Compound (3) | - | 0 part by weight | G | G |
| Example I-4 | Compound (4) | - | 0 part by weight | G | G |
| Example I-5 | Compound (5) | - | 0 part by weight | G | G |
| Comparative Example I-1 | Compound (6) | - | 0 part by weight | N | N |
| Comparative Example I-2 | Compound (7) | - | 0 part by weight | N | N |
| Comparative Example I-3 | Compound (8) | - | 0 part by weight | N | N |
| Comparative Example I-4 | Compound (6) | Compound (9) | 1 part by weight | N | N |
| Comparative Example I-5 | Compound (7) | Compound (9) | 1 part by weight | N | N |
| Comparative Example I-6 | Compound (8) | Compound (9) | 1 part by weight | N | N |
| Comparative Example I-7 | ADEKA OPTMER SP170 | - | 0 part by weight | F | F |

The results on Examples I-1 through I-5 indicate that adhesive compositions comprising an acid generator having a molar extinction coefficient in the range from 3000 to 25000 at a wavelength of 350 nm offered excellent initial adhesiveness and adhesiveness after high-temperature treatment. On the other hand, the compositions comprising an acid generator used in Comparative Examples showed no adhesiveness (Comparative Examples I-1 through I-3) or did not offer sufficient adhesion strength (Comparative Example I-7). Also in the case that a sensitizer was used, a sufficient adhesion strength was not achieved (Comparative Examples I-4 through I-6).

### (Example 1-6)

1 part by weight of a compound (1) as the acid generator (A), 20 parts by weight of a bisphenol A type epoxy resin (trade name "EPIKOTE 828", manufactured by Japan Epoxy Resins Co., Ltd.), as the cationic polymerizable compound (B), 80 parts by weight of an acryl copolymer having a weight average molecular weight of about 520,000 as an adhesive polymer, and 150 parts by weight of methyl ethyl ketone as a solvent were mixed to prepare an adhesive composition. The adhesive composition was applied to a polyethylene terephthalate film (PET film) having a thickness of 200 µm using a bar coater to give a film thickness of 100 µm, and dried to prepare an adhesive film. A silicon chip was bonded to said adhesive film, subsequently the PET film side was irradiated with an ultraviolet ray having a wavelength of 365 nm at a dose of 2400 mJ/cm² using an extra-high pressure mercury lamp. Subsequently the PET film was removed, and immediately the silicon chip bonded to said adhesive film was affixed to copper lead frame to obtain a bonded article. The obtained bonded article was evaluated for the following items. The results are shown in Table 3.

### (Examples I-7 through I-10 and Comparative Examples I-8 through I-14)

Adhesive compositions were prepared and bonded articles comprising a silicon chip and a copper lead frame were obtained in the same manner as Example l-6 except that 1 part by weight of the acid generator (A) in Example l-6 was replaced with 1 part by weight each of the acid generators listed in Table 3, and the sensitizer was replace with a specified amount of compound listed in Table 3. The results of the evaluation on the obtained bonded articles for their initial adhesiveness and adhesiveness after high-temperature treatment are shown in Table 3.

**[Table 3]**

**Results of evaluation on adhesive compositions**

| | | Sensitizer | | | |
|---|---|---|---|---|---|
| | Acid generator (A) | Compound | Addition amount | Initial adhesiveness | Adhesiveness after high-temperature treatment |
| Example I-6 | Compound (1) | - | 0 part by weight | G | G |
| Example I-7 | Compound (2) | - | 0 part by weight | G | G |
| Example I-8 | Compound (3) | - | 0 part by weight | G | G |
| Example I-9 | Compound (4) | - | 0 part by weight | G | G |
| Example I-10 | Compound (5) | - | 0 part by weight | G | G |
| Comparative Example I-8 | Compound (6) | - | 0 part by weight | N | N |
| Comparative Example I-9 | Compound (7) | - | 0 part by weight | N | N |
| Comparative Example I-10 | Compound (8) | - | 0 part by weight | N | N |
| Comparative Example I-11 | Compound (6) | Compound (9) | 1 part by weight | N | N |
| Comparative Example I-12 | Compound (7) | Compound (9) | 1 part by weight | N | N |
| Comparative Example I-13 | Compound (8) | Compound (9) | 1 part by weight | N | N |
| Comparative Example I-14 | ADEKA OPTMER SP170 | - | 0 part by weight | F | F |

The results on Examples I-6 through I-10 indicate that adhesive compositions comprising an acid generator having a molar extinction coefficient in the range from 3000 to 25000 at a wavelength of 350 nm offered excellent initial adhesiveness and adhesiveness after high-temperature treatment. On the other hand, the compositions comprising an acid generator used in Comparative Examples showed no adhesiveness (Comparative Examples I-8 through I-10) or did not offer sufficient adhesion strength (Comparative Example I-14). Also in the case that a sensitizer was used, a sufficient adhesion strength was not achieved (Comparative Examples I-11 through I-13).

### [Sealing composition]

The structures of the acid generators and sensitizers used in Examples and Comparative Examples of the invention are shown in Table 1. The molar extinction coefficients ε of the acid generators at a wavelength of 350 nm are also listed.

### (Example II-1)

2 parts by weight of the compound (1) as the acid generator (A), and 70 parts by weight of a bisphenol A type epoxy resin (trade name "EPIKOTE 828", manufactured by Japan Epoxy Resins Co., Ltd.), and 30 parts by weight of a naphthalene type epoxy resin as the cationic polymerizable compound (B) were mixed to prepare a sealing composition. The prepared sealing composition was injected into a mold of 30 mm in length, 15 mm in width, and 5 mm in depth, thoroughly degassed, in which a silicon device for evaluation having an aluminum wiring of 10 mm square was dipped. Thereafter, photoirradiation was performed at a dose of 3000 mJ/cm² using a mercury-xenon lamp UXM-200YA (manufactured by Ushio Inc.) equipped with a light cut filter for cutting rays having a wavelength of 350 nm or lower. The cured article was sufficiently hardened by the photoirradiation, thus a cured article sealing a silicon device was obtained.

### (Examples II-2 through II-5 and Comparative Examples II-1 through II-6)

Sealing compositions were prepared and test pieces sealing a silicon device were obtained in the same manner as Example II-1 except that 2 parts by weight of the acid generator (A) in Example II-1 were replaced with 2 parts by weight each of the acid generators listed in Table 4 and a specified amount of sensitizer listed in Table 4. The results of the evaluation on the obtained test pieces for their curability, heat cycle resistance, and PCT resistance are shown in Table 4. The test pieces were evaluated by the following evaluation methods.

1) Curability
   5 Sufficiently cured to the inside.
   4 Almost cured to the inside.
   3 Outside is cured but inside is not cured.
   2 Outside is partially not cured.
   1 Scarcely cured.
   0 Wholly not cured.
2) Heat cycle resistance
   The obtained test pieces were left to stand at a temperature of -40°C for 1 minute, and subsequently 100°C for 10 minutes. This cycle was repeated 10 times, and the test pieces were observed for their state.
   G Not particular.
   F Partially cracked.
   N Overall cracked.
3) Pressure cooker test (PCT) resistance
   The test pieces were placed in an autoclave, and left to stand for 300 hours under saturated conditions having a temperature of 121 °C, a pressure of 2 atmospheres, and a relative humidity of 100%. Subsequently the test pieces were taken out and observed for their state.
   G Not particular.
   F Partially discolored in the device area.
   N Wholly colored and the device is corroded.

**Table 4 Evaluation of sealing resin compositions**

| | | Sensitizer | | | | |
|---|---|---|---|---|---|---|
| | Acid generator (A) | Compound | Addition amount | Curability | Heat cycle resistance | PCT resistance |
| Example II-1 | Compound (1) | - | 0 part by weight | 4 | G | G |
| Example II-2 | Compound (2) | - | 0 part by weight | 5 | G | G |
| Example II-3 | Compound (3) | - | 0 part by weight | 4 | G | G |
| Example II-4 | Compound (4) | - | 0 part by weight | 5 | G | G |
| Example II-5 | Compound (5) | - | 0 part by weight | 5 | G | G |
| Comparativ e Example II-1 | Compound (6) | - | 0 part by weight | 0 | - | - |
| Comparativ e Example II-2 | Compound (7) | - | 0 part by weight | 0 | - | - |
| Comparativ e Example II-3 | Compound (8) | - | 0 part by weight | 0 | - | - |
| Comparativ e Example II-4 | Compound (6) | Compound (9) | 1 part by weight | 2 | F | N |
| Comparativ e Example II-5 | Compound (7) | Compound (9) | 1 part by weight | 2 | F | F |
| Comparativ e Example II-6 | Compound (8) | Compound (9) | 1 part by weight | 4 | G | F |

The results on Examples II-1 through II-5 indicate that sealing compositions comprising an acid generator having a molar extinction coefficient in the range from 3000 to 25000 at a wavelength of 350 nm offered excellent curability, heat cycle resistance, and PCT resistance. On the other hand, the compositions comprising an acid generator used in Comparative Examples were not cured at all (Comparative Examples II-1 through II-3) in the absence of sensitizer, or did not offer sufficient sealing properties (Comparative Examples II-4, II-5).

### (Example II-6)

2 parts by weight of the compound (1) as the acid generator (A), 70 parts by weight of a bisphenol A type epoxy resin (trade name "EPIKOTE 828", manufactured by Japan Epoxy Resins Co., Ltd.), and 30 parts by weight of a naphthalene type epoxy resin as the cationic polymerizable compound (B) were mixed to prepare a sealing composition. The prepared sealing composition was applied to a glass plate using a bar coater to give a film thickness of 100 µm, subsequently irradiated with light at a dose of 3000 mJ/cm² using a mercury-xenon lamp UXM-200YA (manufactured by Ushio Inc.) equipped with a light cut filter for cutting rays having a wavelength of 350 nm or lower. The cured article was sufficiently hardened by the photoirradiation, and the cured article was colorless and transparent.

### (Examples II-7 through II-10 and Comparative Examples II-7 through II-12)

A sealing composition was prepared and a cured article was obtained on a glass plate in the same manner as Example II-6 except that 2 parts by weight of the acid generator (A) in Example II-6 were replaced with 2 parts by weight each of the acid generators listed in Table 5 and a specified amount of sensitizer listed in Table 5. The results on the transparency of the obtained cured articles are shown in Table 5.

**Table 5 Evaluation of sealing resin compositions**

| | | Sensitizer | | |
|---|---|---|---|---|
| | Acid generator (A) | Compound | Addition amount | Transparency |
| Example II-6 | Compound (1) | - | 0 part by weight | Colorless and transparent |
| Example II-7 | Compound (2) | - | 0 part by weight | Colorless and transparent |
| Example II-8 | Compound (3) | - | 0 part by weight | Colorless and transparent |
| Example II-9 | Compound (4) | - | 0 part by weight | Colorless and transparent |
| Example II-10 | Compound (5) | - | 0 part by weight | Colorless and transparent |
| Comparative Example II-7 | Compound (6) | - | 0 part by weight | Not cured |
| Comparative Example II-8 | Compound (7) | - | 0 part by weight | Not cured |
| Comparative Example II-9 | Compound (8) | - | 0 part by weight | Not cured |
| Comparative Example II-10 | Compound (6) | Compound (9) | 1 part by weight | Yellow |
| Comparative Example II-11 | Compound (7) | Compound (9) | 1 part by weight | Yellow |
| Comparative Example II-12 | Compound (8) | Compound (9) | 1 part by weight | Reddish brown |

The results on Examples II-6 through II-10 indicate that sealing compositions comprising an acid generator having a molar extinction coefficient in the range from 3000 to 25,000 at a wavelength of 350 nm offered colorless and transparent cured articles. On the other hand, the compositions comprising an acid generator other than those defined in the invention were not cured at all (Comparative Examples II-7 through II-9) in the absence of a sensitizer, or showed deteriorated transparency due to coloring in the presence of a sensitizer. Further, for a composition comprising an iodonium salt as a cation, its curability, heat cycle resistance, and PCT resistance were acceptable (Table 4, Comparatives Example II-6), but the transparency was significantly poor due to the considerable influence of decomposition products of the acid generator as well as the influence of the sensitizer.

### [Preparation of optical waveguide forming material]

### (1) Optical waveguide forming material A (core forming material)

To 100 parts by weight of the cationic polymerizable compound (B) composed of 40 parts by weight of a hydrolysate, which had been obtained through hydrolysis of phenyltrimethoxysilane and methyltrimethoxysilane mixed at a weight ratio of 1:1.35, and 60 parts by weight of methyl isobutyl ketone as a solvent, 2 parts by weight of [2-(4-methoxy-naphthalene-1-yl)-2-oxo-ethyl]-dimethyl-sulfonium-tetrakis(pentafluoroph enyl) borate were added as the acid generator (A). They were uniformly mixed to obtain an optical waveguide forming material A as a core forming material.

### (2) Optical waveguide forming material B (lower clad layer forming material or upper clad layer forming material)

To 100 parts by weight of the cationic polymerizable compound (B) composed of 40 parts by weight of the hydrolysate obtained through hydrolysis of methyltrimethoxysilane and 60 parts by weight of methyl isobutyl ketone, 2 parts by weight of [2-(4-methoxy-naphthalene-1-yl)-2-oxo-ethyl]-dimethyl-sulfonium-tetrakis(pentafluoroph enyl) borate were added as the acid generator (A). They were uniformly mixed to obtain an optical waveguide forming material B as a lower clad layer forming material or upper clad layer forming material.

### (3) Optical waveguide forming material C (core forming material)

To 100 parts by weight of the cationic polymerizable compound (B) composed of 50 parts by weight of a hydrolysate, which had been obtained through hydrolysis of methyltrimethoxysilane and 3-ethyl-3-{[3-(triethoxysilyl)propoxy]methyl}oxetane mixed at a weight ratio of 3.55:1, and 50 parts by weight of propylene glycol monomethyl ether, 2 parts by weight of [2-(4-methoxy-naphthalene-1-yl)-2-oxo-ethyl]-dimethyl-sulfonium-tetrakis(pentafluoroph enyl) borate were added as the acid generator (A). They were uniformly mixed to obtain an optical waveguide forming material C as a core forming material.

### (Example III-1)

The optical waveguide forming material B was applied to the surface of a silicon substrate using a spin coater, and dried at a temperature of 70°C for 10 minutes. Thereafter, photoirradiation was performed at a dose of 1000 mJ/cm² through a bandpass filter which selectively pass light having a wavelength of 365 nm to form a lower clad layer having a thickness of 10 µm. The refractive index of light having a wavelength of 1550 nm was 1.423 in the lower clad layer. Subsequently, the optical waveguide forming material A was applied to the lower clad layer using a spin coater, and dried at a temperature of 70°C for 10 minutes. Thereafter, exposure was performed by photoirradiation at a dose of 1000 mJ/cm² through a bandpass filter which selectively passes light having a wavelength of 365 nm using a photomask having a waveguide pattern of 4 to 20 µm width. Thereafter, the substrate was dipped in a developing solution comprising ethanol for dissolving unexposed areas to form a core having a thickness of 7 µm. The refractive index of light having a wavelength of 1550 nm was 1.452 in the core. Further, the optical waveguide forming material B was applied to the upper surface of the lower clad layer having the core using a spin coater, and dried at a temperature of 70°C for 10 minutes. Subsequently, photoirradiation was performed at a dose of 1000 mJ/cm² through a bandpass filter which selectively passes light having a wavelength of 365 nm to form an upper clad layer having a thickness of 15 µm, thus an optical waveguide was formed. The refractive index of light having a wavelength of 1550 nm was 1.423 in the upper clad layer formed above.

### (Example III-2)

An optical waveguide was formed and its refractive index was measured in the same manner as Example III-1 except that the optical waveguide forming material A in Example III-1 was replaced with an optical waveguide forming material C. The result indicates that the refractive index of light having a wavelength of 1550 nm was 1.423 in the lower clad layer formed above, 1.436 in the core, and 1.423 in the upper clad layer.

### [Industrial applicability]

According to Examples of the invention, the adhesive composition is cured by irradiation with a small amount of an active energy line, and offers high heat resistance, durability, transparency, and adhesion strength after crosslinking curing with an energy line. Further, according to Examples of the invention, the adhesive composition comprises the acid generator (A), hence it efficiently generates a strong acid even by irradiation with a small amount of energy line, which allows the reduction of the irradiation time of an active energy line to improve processability, and the reduction of deterioration of the base material due to energy line irradiation. Further, according to Examples of the invention, the adhesive film has initial adhesiveness, it thus serves as a dicing tape by affixing it to the surface of a semiconductor device to be bonded to a supporting member before dicing. The adhesive composition of the invention is particularly useful as an adhesive for die bonding applications.

According to Examples of the invention, the sealing composition is cured by irradiation with a small amount of an active energy line, and offers high heat resistance, durability, transparency, and adhesion strength after crosslinking curing with an energy line. Further, according to Examples of the invention, the sealing composition comprises the acid generator (A), hence it rapidly promotes cation polymerization to a desired degree of polymerization by irradiation with an energy line, and thus offers high processability and adhesiveness. Further, according to Examples of the invention, the composition efficiently generates a very strong acid even by irradiation with a small amount of an energy line, which allows the reduction of the irradiation time of an active energy line to improve processability, and the reduction of deterioration of base materials due to energy line irradiation. The sealing composition of the invention is useful for sealing semiconductor electronic components such as a diode, transistor, and lC, display devices such as liquid crystal panel, plasma display panel, and electroluminescence (hereinafter referred to as EL) devices, high-density recording media such as a magneto-optical disk, solar battery, and optical waveguide.

According to one embodiment of the invention, the optical waveguide forming material is very easily cured in a short time by irradiation with a small amount of active energy line. Further, according to one embodiment of the invention, the optical waveguide forming material permits patternwise exposure, or the refractive index thereof can be changed by irradiation with an active energy line, which facilitates the formation of an optical waveguide. The optical waveguide forming material of the invention may be used for the production of optical waveguides at low cost and with excellent mass productivity.

## Claims

1. A polymerizable composition comprising an acid generator (A) containing
a sulfonium cation and a borate anion represented by the following general formula (1):
[BYₘZₙ]⁻ general formula (1)
wherein, Y represents a fluorine or chlorine atom, Z represents a phenyl group substituted with two or more groups selected from a fluorine atom, cyano group, nitro group, and trifluoromethyl group, m represents an integer from 0 to 3, n represents an integer from 1 to 4, and m+n=4, and
a cationic polymerizable compound (B).

2. An adhesive composition comprising the composition according to Claim 1, wherein the acid generator (A) has a molar extinction coefficient in the range from 3000 to 25000 at a wavelength of 350 nm in acetonitrile.

3. The adhesive composition according to Claim 2, wherein the sulfonium cation is represented by the general formula (2): 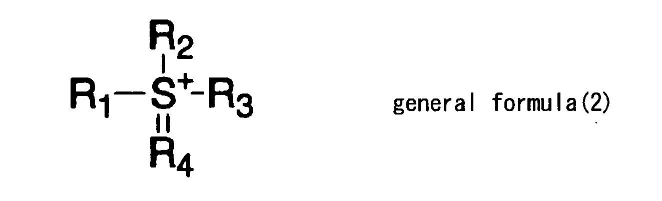 wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, R₄ represents an oxygen atom or lone pair, and two or more of R_{1'} R₂, and R₃ may be bonded to form a cyclic structure.

4. The adhesive composition according to Claim 2, wherein the cationic polymerizable compound is a compound having within the molecule thereof at least one epoxy group or at least one oxetanyl group.

5. A die bonding adhesive comprising the adhesive composition according to Claim 4.

6. A die bonding adhesive film obtained by applying the adhesive according to Claim 5 to a base material.

7. A process for producing a bonded article bonding a semiconductor device and a supporting member, wherein a layer containing the adhesive according to Claim 5 is formed between the semiconductor device and the supporting member, subsequently the adhesive or adhesive film is cured by irradiation with light containing at least a portion of rays having a wavelength from 350 nm to 450 nm.

8. A process for producing a bonded article bonding a semiconductor device and a supporting member, wherein a layer containing the adhesive according to Claim 5 is formed on the surface of the semiconductor device to be bonded to the supporting member, and laminated to the supporting member after irradiation with light containing at least a portion of rays having a wavelength from 350 nm to 450 nm.

9. A sealing composition comprising the composition according to Claim 1, wherein the acid generator (A) has a molar extinction coefficient in the range from 3000 to 25000 at a wavelength of 350 nm.

10. The sealing composition according to Claim 9, wherein the sulfonium cation is represented by the general formula (2): 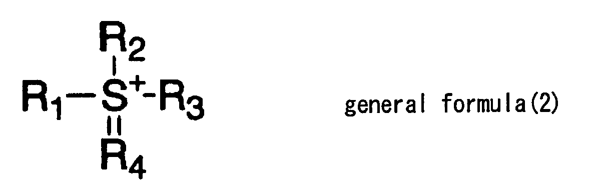 wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, R₄ represents an oxygen atom or lone pair, and two or more of R_{1'} R₂, and R₃ may be bonded to form a cyclic structure.

11. The sealing composition according to Claim 9, wherein the cationic polymerizable compound is a compound having within the molecule thereof at least one epoxy group or at least one oxetanyl group.

12. A sealant comprising the sealing composition according to Claim 11.

13. A process for producing a sealed article, wherein the sealant according to Claim 12 is applied to or charged into a part of or all over the base material, and irradiated with light containing at least a portion of rays having a wavelength from 350 nm to 450 nm to cure the sealant.

14. A process for sealing a base material, wherein the sealant according to Claim 12 is applied to or charged into a part of or all over the base material, and irradiated with light containing at least a portion of rays having a wavelength from 350 nm to 450 nm to cure the sealant.

15. An optical waveguide forming material comprising the composition according to Claim 1, wherein the acid generator (A) has a molar extinction coefficient in the range from 500 to 25000 at a wavelength of 365 nm.

16. The optical waveguide forming material according to Claim 15, wherein the sulfonium cation is represented by the general formula (2): 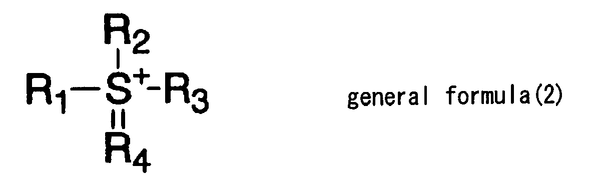 wherein R₁ represents a group selected from a substituted benzyl group, substituted phenacyl group, substituted allyl group, substituted alkoxyl group, substituted aryloxy group, and substituted heterocyclic oxy group, R₂ and R₃ each independently represents a group selected from a benzyl group, phenacyl group, allyl group, alkoxyl group, aryloxy group, heterocyclic oxy group, alkyl group, and alkenyl group, and substituted derivatives thereof, R₄ represents an oxygen atom or lone pair, and two or more of R_{1'} R₂, and R₃ may be bonded to form a cyclic structure.

17. The optical waveguide forming material according to Claim 15, wherein the cationic polymerizable compound (B) is a compound having within the molecule thereof at least one epoxy group or at least one oxetanyl group, or a hydrolysate of a hydrolysable silane compound.

18. An optical waveguide formed by curing the optical waveguide forming material according to any one of Claims 15 through 17.

19. A process for producing an optical waveguide having a core and a clad layer, wherein the optical waveguide forming material according to any one of Claims 15 through 17 is applied to a substrate such that it forms at least either a core or a clad layer, and then cured by photoirradiation.

20. An optical waveguide produced by the process for producing an optical waveguide according to Claim 19.
